# EUROPEAN PATENT APPLICATION

(11) **EP 4 819 800 A1**
(43) Date of publication of application: **07.10.2026**
(21) Application number: 24897631.8
(22) Date of filing: 28.11.2024
(51) Int. Cl.: H10F 39/12

(54) **SEMICONDUCTOR PACKAGE, ELECTRONIC DEVICE, AND MANUFACTURING METHOD**

(30) Priority: 28.11.2023 JP 2023200906
(71) Applicant: Sony Semiconductor Solutions Corporation, Atsugi-shi, Kanagawa 243-0014 (JP)
(72) Inventor: WATANABE, Tsuyoshi, Atsugi-shi, Kanagawa 243-0014 (JP); TANAKA, Yuto, Atsugi-shi, Kanagawa 243-0014 (JP)
(74) Representative: MFG Patentanwälte Meyer-Wildhagen Meggle-Freund Gerhard PartG mbB
(86) International application number: PCT/JP2024/042123
(87) International publication number: WO 2025/115947

(57) **Abstract**

The present technology relates to a semiconductor package, an electronic device, and a manufacturing method capable of improving heat dissipation performance.

The semiconductor package includes a sheet formed by using a material having thermal conductivity, a semiconductor chip arranged on an upper surface side of the sheet and including a pixel array section including a photoelectric conversion element and a peripheral circuit section, and a circuit board arranged on a lower surface side of the sheet and processing a signal from the semiconductor chip, in which the sheet includes a gap in which a wire connecting an electrode of the semiconductor chip and an electrode of the circuit board is wired, a first region in which the semiconductor chip is arranged, a second region surrounding the first region via the gap, a connecting portion connecting the first region and the second region, and a third region connected to the second region and having at least a part arranged outside the package. The present technology can be applied to, for example, a semiconductor package including an image pickup element.

## Description

### TECHNICAL FIELD

The present technology relates to a semiconductor package, an electronic device, and a manufacturing method, and for example, relates to a semiconductor package, an electronic device, and a manufacturing method having high heat dissipation performance.

### BACKGROUND ART

Image pickup elements such as charge-coupled device (CCD) image sensors and complementary metal-oxide-semiconductor (CMOS) image sensors to which semiconductor microfabrication technology is applied are widely adopted in digital cameras, mobile phones, and the like. Patent Documents 1 to 3 propose to dissipate heat generated in a chip of an image pickup element.

### CITATION LIST

### PATENT DOCUMENT

Patent Document 1: Japanese Patent Application Laid-Open No. 2023-21774
Patent Document 2: Japanese Patent Application Laid-Open No. 2021-36587
Patent Document 3: Japanese Patent Application Laid-Open No. 2019-50418

### SUMMARY OF THE INVENTION

### PROBLEMS TO BE SOLVED BY THE INVENTION

It is desired to efficiently dissipate heat generated in a chip of an image pickup element from the chip to an outside.

The present technology has been made in view of such a situation, and enables efficient heat dissipation from a chip to an outside.

### SOLUTIONS TO PROBLEMS

A semiconductor package according to one aspect of the present technology is a semiconductor package including a sheet formed by using a material having thermal conductivity, a semiconductor chip arranged on an upper surface side of the sheet and including a pixel array section including a photoelectric conversion element and a peripheral circuit section, and a circuit board arranged on a lower surface side of the sheet and processing a signal from the semiconductor chip, in which the sheet includes a gap in which a wire connecting an electrode of the semiconductor chip and an electrode of the circuit board is wired, a first region in which the semiconductor chip is arranged, a second region surrounding the first region via the gap, a connecting portion connecting the first region and the second region, and a third region connected to the second region and having at least a part arranged outside the package.

An electronic device according to one aspect of the present technology is an electronic device including a semiconductor package that includes a sheet formed by using a material having high thermal conductivity, a semiconductor chip arranged on an upper surface side of the sheet and having a pixel array section having a photoelectric conversion element and a peripheral circuit section, and a circuit board arranged on a lower surface side of the sheet and processing a signal from the semiconductor chip, the sheet including a gap in which a wire connecting an electrode of the semiconductor chip and an electrode of the circuit board is wired, a first region in which the semiconductor chip is arranged, a second region surrounding the first region via the gap, a connecting portion connecting the first region and the second region, and a third region connected to the second region and having at least a part arranged outside the package.

A manufacturing method according to one aspect of the present technology is a manufacturing method including bonding, by a first adhesive, a semiconductor chip to an upper surface side of a sheet including a gap in which a wire connecting an electrode of the semiconductor chip and an electrode of a circuit board is wired, a first region in which the semiconductor chip is arranged, a second region surrounding the first region via the gap, a connecting portion connecting the first region and the second region, and a third region connected to the second region and having at least a part arranged outside a package, and bonding the circuit board to a lower surface side of the sheet by a second adhesive having an elastic modulus lower than an elastic modulus of the first adhesive.

The semiconductor package according to one aspect of the present technology includes the sheet formed by using the material having thermal conductivity, the semiconductor chip arranged on the upper surface side of the sheet and including the pixel array section including the photoelectric conversion element and the peripheral circuit section, and the circuit board arranged on the lower surface side of the sheet and processing the signal from the semiconductor chip. The sheet includes the gap in which the wire connecting the electrode of the semiconductor chip and the electrode of the circuit board is wired, the first region in which the semiconductor chip is arranged, the second region surrounding the first region via the gap, the connecting portion connecting the first region and the second region, and the third region connected to the second region and having at least a part arranged outside the package.

The electronic device according to one aspect of the present technology includes the semiconductor package.

The manufacturing method according to one aspect of the present technology includes bonding, by the first adhesive, the semiconductor chip to the upper surface side of the sheet including the gap in which the wire connecting the electrode of the semiconductor chip and the electrode of the circuit board is wired, the first region in which the semiconductor chip is arranged, the second region surrounding the first region via the gap, the connecting portion connecting the first region and the second region, and the third region connected to the second region and having at least a part arranged outside the package, and bonding the circuit board to the lower surface side of the sheet by the second adhesive having the elastic modulus lower than the elastic modulus of the first adhesive.

Note that the electronic device may be an independent device, or may be an internal block constituting one device.

### BRIEF DESCRIPTION OF DRAWINGS

Fig. 1 is a diagram illustrating a configuration of an embodiment of an imaging device to which the present technology is applied.
Fig. 2 is a diagram illustrating an example of a shape of a heat dissipation sheet.
Fig. 3 is a diagram illustrating a state of the heat dissipation sheet arranged on a circuit board.
Fig. 4 is a diagram illustrating an example of a shape of a joint portion.
Fig. 5 is a diagram for explaining another effect of the heat dissipation sheet.
Fig. 6 is a diagram for explaining manufacturing of the imaging device.
Fig. 7 is a diagram for explaining manufacturing of the imaging device.
Fig. 8 is a diagram illustrating a configuration example of an electronic device.
Fig. 9 is a diagram illustrating a cross-sectional configuration example of an imaging device according to a second embodiment.
Fig. 10 is a diagram illustrating a planar configuration example of the imaging device according to the second embodiment.
Fig. 11 is a diagram for explaining manufacturing of the imaging device according to the second embodiment.
Fig. 12 is a diagram for explaining manufacturing of the imaging device according to the second embodiment.
Fig. 13 is a diagram for explaining the number of times of cutting at the time of singulation.
Fig. 14 is a diagram for explaining another manufacturing of the imaging device according to the second embodiment.
Fig. 15 is a diagram for explaining another manufacturing of the imaging device according to the second embodiment.
Fig. 16 is a diagram illustrating a cross-sectional configuration example of an imaging device according to a third embodiment.
Fig. 17 is a diagram for explaining manufacturing of the imaging device according to the third embodiment.
Fig. 18 is a diagram for explaining manufacturing of the imaging device according to the third embodiment.
Fig. 19 is a diagram for explaining another manufacturing of the imaging device according to the third embodiment.
Fig. 20 is a diagram for explaining another manufacturing of the imaging device according to the third embodiment.
Fig. 21 is a diagram illustrating a surface configuration example of a circuit board according to the third embodiment.
Fig. 22 is a diagram illustrating a cross-sectional configuration example of the imaging device according to the third embodiment.
Fig. 23 is a diagram for explaining connection with a housing.
Fig. 24 is a diagram illustrating an example of a schematic configuration of an endoscopic surgery system.
Fig. 25 is a block diagram illustrating an example of a functional configuration of a camera head and a CCU.
Fig. 26 is a block diagram illustrating an example of a schematic configuration of a vehicle control system.
Fig. 27 is an explanatory diagram illustrating an example of installation positions of an outside-vehicle information detecting section and an imaging section.

### MODE FOR CARRYING OUT THE INVENTION

A mode for carrying out the present technology (hereinafter, referred to as an embodiment) will be described hereinafter.

### <Configuration of Image Pickup Element>

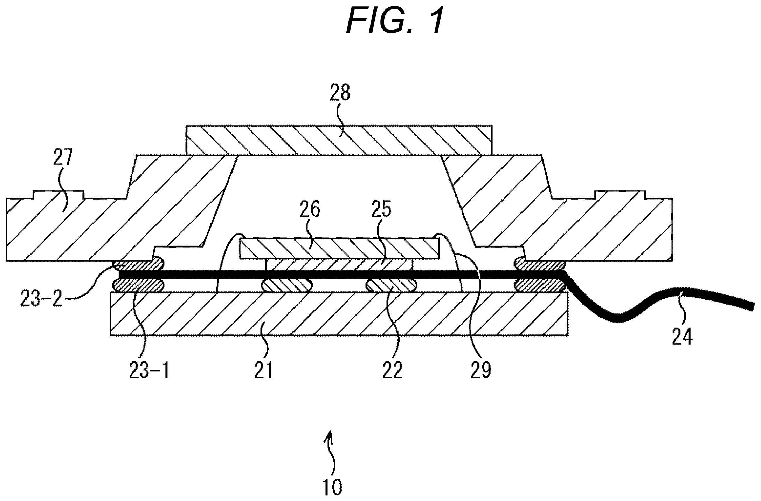

Fig. 1 is a diagram illustrating a configuration of an embodiment of a semiconductor package to which the present technology is applied. Fig. 1 is a schematic cross-sectional view of a semiconductor package 10. In Fig. 1, the semiconductor package 10 houses and packages a semiconductor chip 26 as an image sensor.

Thermosetting resin 22 is arranged at a center on a circuit board 21 of the semiconductor package 10, and an adhesive 23-1 is arranged at an end. A heat dissipation sheet 24 is arranged on the thermosetting resin 22 and the adhesive 23-1. The semiconductor chip 26 is arranged at a central portion on an upper surface side of the heat dissipation sheet 24 via a thermosetting resin 25.

An adhesive 23-2 is arranged in a region on the upper surface side of the heat dissipation sheet 24 where the adhesive 23-1 is arranged, and a frame 27 is arranged on the adhesive 23-2. A glass substrate 28 is arranged at a central portion of the frame 27. The semiconductor chip 26 is in a state of being sealed by the circuit board 21, the frame 27, and the glass substrate 28.

The adhesive 23-1 functions as an adhesive for bonding the circuit board 21 and the heat dissipation sheet 24. The adhesive 23-2 functions as an adhesive for bonding the heat dissipation sheet 24 and the frame 27. The same material or different materials may be used for the adhesive 23-1 and the adhesive 23-2. Furthermore, as the adhesive 23-1 and the adhesive 23-2, a thermosetting resin can be used. The adhesive 23-1 and the adhesive 23-2 also have a function of fixing and holding the frame 27 on the circuit board 21.

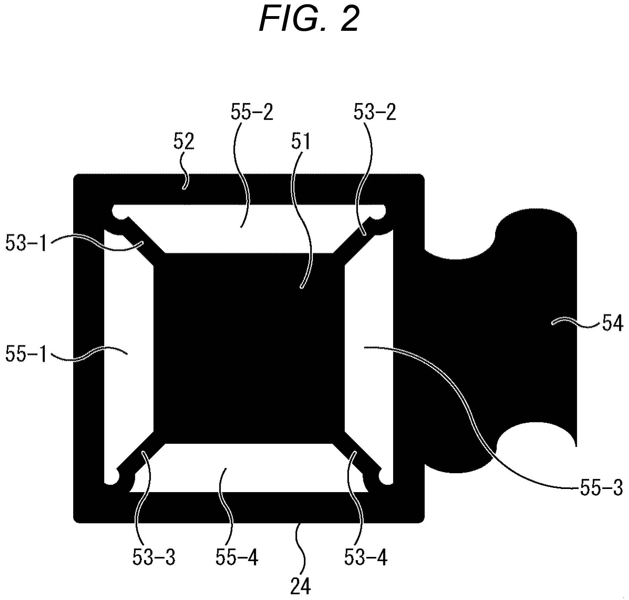

The heat dissipation sheet 24 is fixed in a state of being sandwiched between the circuit board 21 and the frame 27. The heat dissipation sheet 24 absorbs and conducts heat generated in the semiconductor chip 26 and releases the heat to an outside of the semiconductor package 10. The heat dissipation sheet 24 is drawn out to the outside of the semiconductor package 10 in a planar direction, and a heat dissipation member is connected to a housing. Note that a direction in which the heat dissipation sheet 24 is drawn out is appropriately changed according to a structure of a camera or the like on which the semiconductor package 10 is mounted. Furthermore, a plurality of portions may be drawn out instead of one portion. A shape and the like of the heat dissipation sheet 24 will be described later with reference to Fig. 2.

The thermosetting resin 22 is provided between the heat dissipation sheet 24 and the circuit board 21. The thermosetting resin 22 functions as an adhesive for bonding the heat dissipation sheet 24 and the circuit board 21, and also functions as a holding portion for supporting the semiconductor chip 26 arranged on the heat dissipation sheet 24. The thermosetting resin 22 is provided in a shape having a void at a central portion. The thermosetting resin 22 is provided such that a space surrounded by the circuit board 21, the heat dissipation sheet 24, and the thermosetting resin 22 is present between the circuit board 21 and the heat dissipation sheet 24.

As the heat dissipation sheet 24, a thin flexible graphite sheet having high thermal conductivity, a sheet containing metal or ceramic, for example, a copper foil sheet, an aluminum foil sheet, or the like is used.

The semiconductor chip 26 is, for example, a complementary metal-oxide-semiconductor (CMOS) image sensor, a charge-coupled device (CCD) image sensor, or the like. The semiconductor chip 26 includes a pixel array section in which a plurality of pixels each having a photoelectric conversion element (PD: photodiode) for converting incident light into a charge is two-dimensionally arranged in a matrix, and a peripheral circuit section for driving the pixels, performing analog/digital (A/D) conversion, and the like.

Electrodes of the semiconductor chip 26 and electrodes of the circuit board 21 are connected by a wire 29, and a signal obtained in the semiconductor chip 26 is supplied to a circuit of the circuit board 21 and processed.

The thermosetting resin 25 is provided between the heat dissipation sheet 24 and the semiconductor chip 26. The thermosetting resin 25 functions as an adhesive for bonding the heat dissipation sheet 24 and the semiconductor chip 26, and also has a function of efficiently conducting heat generated in the semiconductor chip 26 to the heat dissipation sheet 24.

The thermosetting resin 22 is provided on the lower surface side (lower side in the drawing) of the heat dissipation sheet 24, and the thermosetting resin 25 is provided on the upper surface side (upper side in the drawing). The thermosetting resin 22 and the thermosetting resin 25 are formed by using materials having different characteristics. The thermosetting resin 22 provided on the circuit board 21 side is a thermosetting resin having a low elastic modulus, and for example, a resin having an elastic modulus of about 5 MPa to 500 MPa is used. The thermosetting resin 25 provided on the semiconductor chip 26 side is a thermosetting resin having a small linear expansion coefficient, a high elastic modulus, and high thermal conductivity, and for example, a resin having an elastic modulus of about 500 MPa to 1 GPa is used.

As described above, different materials are used above and below the heat dissipation sheet 24, and thus, it is possible to prevent the circuit board 21 and the semiconductor chip 26 from being warped. In a case where the thermosetting resin 22 and the thermosetting resin 25 are formed by using the same material, there is a possibility that the circuit board 21 and the semiconductor chip 26 are warped when a temperature changes due to a difference in linear expansion coefficient between the circuit board 21 and the semiconductor chip 26.

The thermosetting resin 22 and the thermosetting resin 25 are formed by using different materials, and it is possible to suppress the influence of fluctuations in the warpage occurring in the circuit board 21 and the semiconductor chip 26 when the temperature changes. Furthermore, as described later, since the heat dissipation sheet 24 has a shape for suppressing the fluctuations in the warpage, the influence of the warpage can be further reduced.

### <Shape of Heat Dissipation Sheet>

Fig. 2 is a diagram illustrating a configuration of the heat dissipation sheet 24 in plan view. The heat dissipation sheet 24 includes a central portion 51 at a center, and a peripheral portion 52 is provided so as to surround the central portion 51. The central portion 51 and the peripheral portion 52 are connected by connecting portions 53-1 to 53-4. A drawer portion 54 drawn out to the outside of the semiconductor package 10 on a right side in the drawing is provided in the heat dissipation sheet 24.

The central portion 51 is a region where the semiconductor chip 26 is bonded with the thermosetting resin 25, and is formed in a quadrangular shape. The peripheral portion 52 is a region to which the frame 27 is bonded with the adhesive 23, and is formed in a quadrangular shape of a line having a predetermined width.

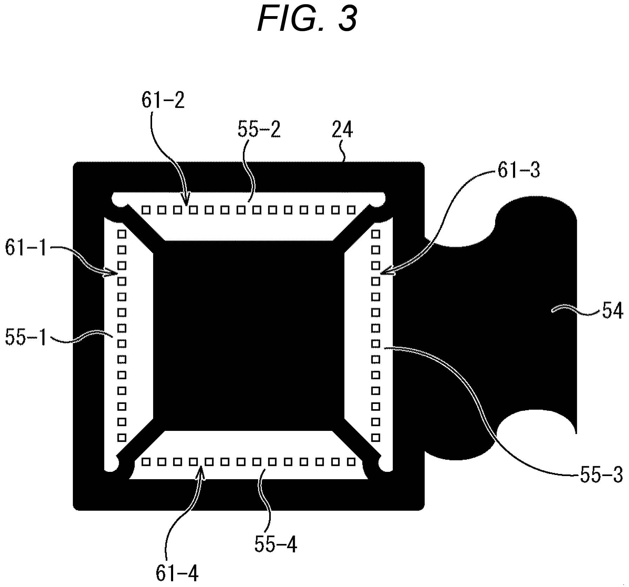

Between the central portion 51 and the peripheral portion 52, gaps 55-1 to 55-4 in which the wire 29 connecting the electrodes (inner leads) of the circuit board 21 and the electrodes of the semiconductor chip 26 is wired are provided. As illustrated in Fig. 3, the gaps 55-1 to 55-4 are regions provided such that inner leads 61-1 to 61-4 of the circuit board 21 are visible in a plan view when the gaps are overlapped with the circuit board 21, and are gaps provided in the heat dissipation sheet 24, as regions for wiring the wire 29 to be wire-bonded.

The adhesives 23 are applied to the peripheral portion 52, and the peripheral portion is a region where the circuit board 21 and the frame 27 are in contact with and bonded to each other. The connecting portions 53-1 to 53-4 are provided in a region avoiding the gaps 55-1 to 54-4, and connect the central portion 51 and the peripheral portion 52. Hereinafter, in a case where it is not necessary to individually distinguish the connecting portions 53-1 to 53-4, these connecting portions are simply described as the connecting portions 53. Other parts will be described in a similar manner.

In the example illustrated in Fig. 2, the connecting portions 53 are provided at positions connecting four corners of the central portion 51 and four corners of the peripheral portion 52. The connecting portion 53 may also be provided in a region in the gap 55 where the wire 29 (inner lead 61) is not wired.

In the example illustrated in Fig. 2, an example in which the drawer portion 54 is provided on the right side of the peripheral portion 52 in the drawing, which is formed in the quadrangular shape, has been illustrated. However, a shape in which drawer portions 54 are provided on two sides, three sides, or four sides among four sides of the peripheral portion 52 may be adopted.

In the central portion 51 of the heat dissipation sheet 24, the heat generated in the semiconductor chip 26 is absorbed, conducted from the central portion 51 to the peripheral portion 52 via the connecting portions 53, and conducted from the peripheral portion 52 to the drawer portion 54. Since the drawer portion 54 is arranged outside the semiconductor package 10, the heat from the semiconductor chip 26 can be dissipated to the outside of the semiconductor package 10.

### <Shape of Connecting Portion>

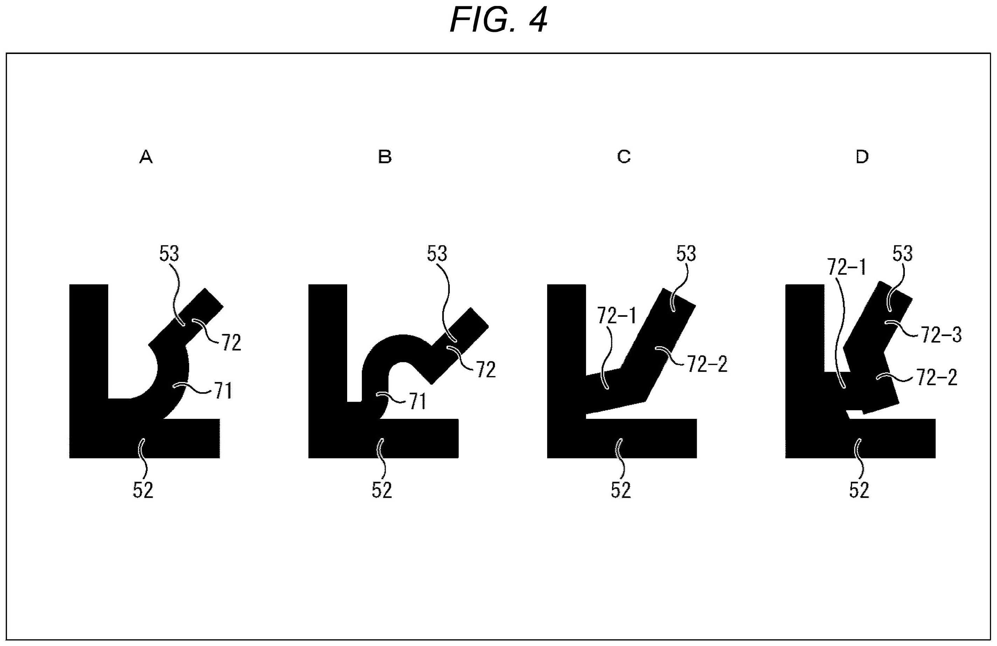

A shape of the connecting portion 53 will be described with reference to Fig. 4. As illustrated in A of Fig. 4, the connecting portion 53 includes a curved portion 71 and a straight portion 72. The curved portion 71 has a curved shape, and the straight portion 72 has a straight shape. The connecting portion 53 includes the curved portion 71. Thus, it is possible to absorb the influence of the fluctuations in the warpage occurring in the circuit board 21 and the semiconductor chip 26 when the temperature changes, and it is possible to suppress the warpage of the circuit board 21 and the semiconductor chip 26.

Widths of the curved portion 71 and the straight portion 72 constituting the connecting portion 53 are the same. That is, the connecting portion 53 is formed in a line shape having the same width. When there is a portion having a narrow width in the connecting portion 53, there is a possibility that the heat conduction is obstructed at this portion and the heat is accumulated. The width of the connecting portion 53 is formed to be substantially uniform so as not to have such a portion where the heat is accumulated.

When a region where the connecting portion 53 and the peripheral portion 52 are connected is formed to be wide, the heat conduction from the connecting portion 53 to the peripheral portion 52 can be more efficiently performed.

The connecting portion 53 is provided to connect the central portion 51 and the peripheral portion 52 while avoiding the inner leads 61. Since the connecting portion 53 serves as a heat dissipation path, the connecting portion is formed to have a width as wide as possible without interfering with the inner lead 61.

The curved portion 71 is provided in the connecting portion 53. Thus, it is possible to alleviate stress generated between the central portion 51 in contact with the semiconductor chip 26 and the peripheral portion 52 in contact with the frame 27 due to the temperature change, and it is possible to suppress the warpage of the circuit board 21 and the semiconductor chip 26.

B of Fig. 4 is a diagram illustrating another shape of the connecting portion 53. The connecting portion 53 illustrated in B of Fig. 4 also includes the curved portion 71 and the straight portion 72 similarly to the connecting portion 53 illustrated in A of Fig. 4, but the shape of the curved portion 71 is different. The curved portion 71 illustrated in A of Fig. 4 has an arc positioned on a lower side in the drawing, whereas the curved portion 71 illustrated in B of Fig. 4 has an arc positioned on an upper side in the drawing.

The shape of the curved portion 71 is not limited to the shapes illustrated in A of Fig. 4 and B of Fig. 4, and may be other shapes.

C of Fig. 4 is a diagram illustrating another shape of the connecting portion 53. The connecting portion 53 illustrated in C of Fig. 4 has a straight portion 72-1 and a straight portion 72-2. The straight portion 72-1 and the straight portion 72-2 are connected (integrally formed) such that an angle A formed by the straight portion 72-1 and a predetermined side of the peripheral portion 52, for example, a lower side in the drawing, and an angle B formed by the straight portion 72-2 and the predetermined side of the peripheral portion 52 are different angles.

D of Fig. 4 is a diagram illustrating another shape of the connecting portion 53. The connecting portion 53 illustrated in D of Fig. 4 includes the straight portion 72-1, the straight portion 72-2, and a straight portion 72-3. The straight portion 72-1, the straight portion 72-2, and the straight portion 72-3 are connected (integrally formed) such that an angle A formed by the straight portion 72-1 and a predetermined side of the peripheral portion 52, an angle B formed by the straight portion 72-2 and the predetermined side of the peripheral portion 52, and an angle C formed by the straight portion 72-3 and the predetermined side of the peripheral portion 52 are different angles.

The connecting portion 53 illustrated in C of Fig. 4 and D of Fig. 4 is formed to have a bent shape by having a shape in which straight lines each having a predetermined width are combined. The connecting portion 53 has the bent shape. Thus, it is possible to alleviate the stress generated between the central portion 51 in contact with the semiconductor chip 26 and the peripheral portion 52 in contact with the frame 27 due to the temperature change, and it is possible to suppress the warpage of the circuit board 21 and the semiconductor chip 26.

The shape of the straight portion 72 is not limited to the shapes illustrated in A to D of Fig. 4, and may be another shape, a shape having a curved portion or a shape having a bent portion, and may be any shape as long as stress can be alleviated.

As the connecting portions 53-1 to 53-4 of the heat dissipation sheet 24, any one shape from A to D in Fig. 4 may be applied, or a plurality of shapes may be applied. For example, the shape of the connecting portion 53 illustrated in A of Fig. 4 is applied to the connecting portion 53-1 and the connecting portion 53-4 (see Fig. 2) at facing positions, and the shape of the connecting portion 53 illustrated in C of Fig. 4 is applied to the connecting portion 53-2 and the connecting portion 53-3. Thus, the connecting portions 53 having different shapes may be provided in one heat dissipation sheet 24.

As illustrated in Fig. 2, an example in which the connecting portions 53 are provided at the positions corresponding to the four corners of the semiconductor chip 26 has been illustrated. However, the connecting portions may be provided at positions other than the four corners of the semiconductor chip 26 or at positions where the inner leads 61 are not arranged in addition to the four corners. The number of connecting portions 53 is increased. Thus, the heat dissipation path connecting the central portion 51 and the peripheral portion 52 increases, and heat dissipation efficiency can be enhanced.

### <Other Effects>

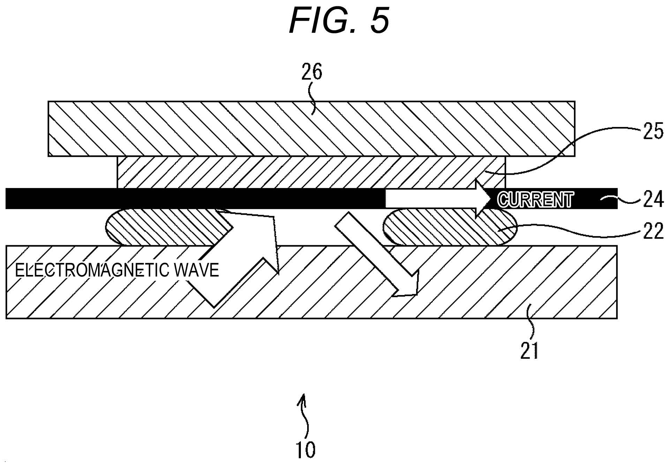

The heat dissipation sheet 24 is provided, and thus, heat generated in the semiconductor package 10 can be efficiently dissipated to the outside of the semiconductor package 10. Moreover, noise can be reduced by providing the heat dissipation sheet 24. These effects will be described with reference to Fig. 5.

Fig. 5 is an enlarged view of a portion of the heat dissipation sheet 24 in the semiconductor package 10 illustrated in Fig. 1. In the circuit board 21, an electromagnetic wave may be generated. For example, the heat dissipation sheet 24 is formed by using a material such as graphite that absorbs the electromagnetic wave, and thus, the electromagnetic wave generated in the circuit board 21 can be attenuated by the heat dissipation sheet 24. The electromagnetic wave absorbed by the heat dissipation sheet 24 propagates, as a current, through the heat dissipation sheet 24 and is emitted to the outside.

The heat dissipation sheet 24 is provided. Thus, the electromagnetic wave generated in the circuit board 21 can be attenuated, and the semiconductor chip 26 can be prevented from being influenced. Accordingly, electromagnetic wave noise generated between the circuit board 21 and the semiconductor chip 26 can be reduced.

### <About Manufacturing of Semiconductor Package>

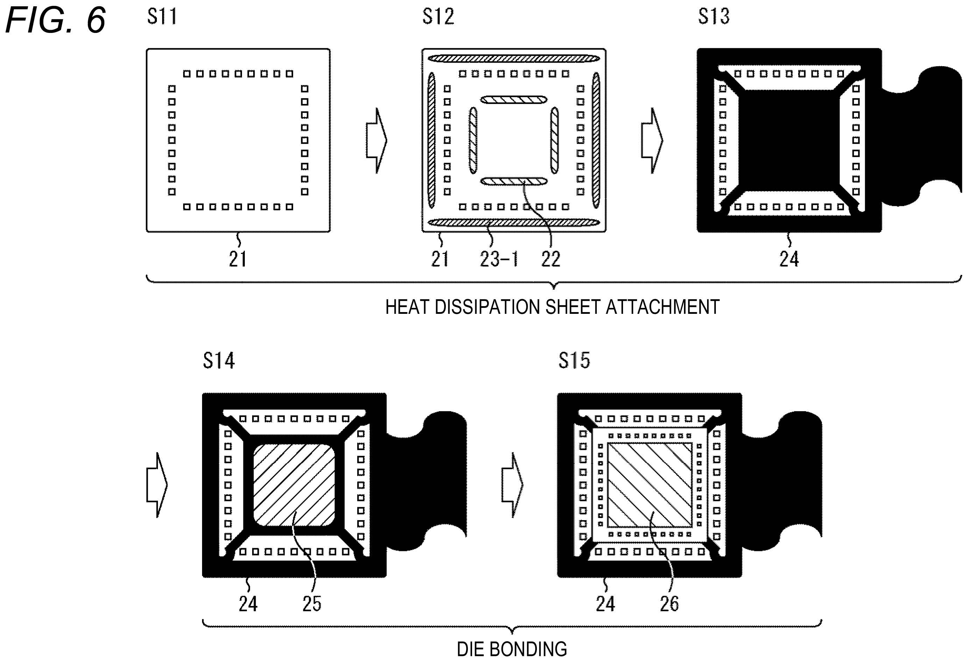

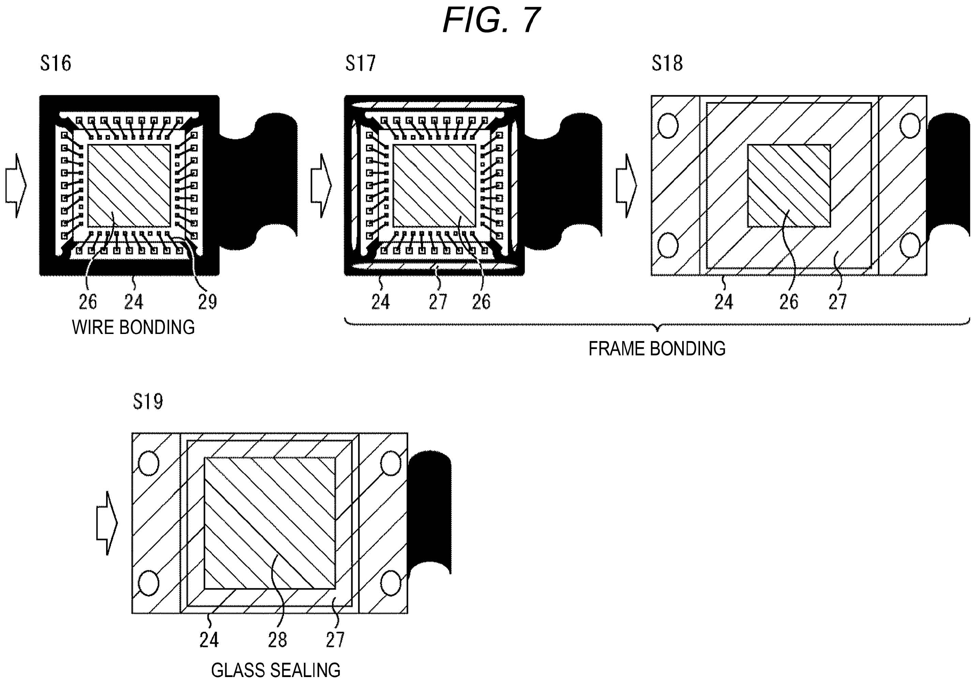

The manufacturing of the semiconductor package 10 illustrated in Fig. 1 will be described with reference to Figs. 6 and 7.

In step S11 to step S13, attachment of the heat dissipation sheet 24 is performed. In step S11, the circuit board 21 on which a circuit is formed is prepared. A plurality of quadrangles on the circuit board 21 illustrated in step S11 indicates electrodes (inner leads 61) to be wire-bonded.

In step S12, the thermosetting resin 22 and the adhesive 23-1 are applied to the circuit board 21. As illustrated in step S12, the thermosetting resin 22 is applied to a position where the semiconductor chip 26 is arranged, specifically to positions corresponding to four sides of the semiconductor chip 26. The adhesive 23-1 is applied to a position corresponding to a position where the frame 27 is arranged, specifically to four sides of the circuit board 21.

In step S13, the heat dissipation sheet 24 is brought into close contact with the circuit board 21 to which the thermosetting resin 22 and the adhesive 23-1 are applied, and heating is performed to cure the thermosetting resin 22 and the adhesive 23-1.

In step S14 and step S15, die bonding is performed. In step S14, the thermosetting resin 25 is applied to the entire surface of a region of the heat dissipation sheet 24 where the semiconductor chip 26 is arranged.

In step S15, the semiconductor chip 26 is mounted on the heat dissipation sheet 24 by being brought into close contact with the region to which the thermosetting resin 25 is applied, and heat treatment is performed to thermally cure the thermosetting resin 25. By such a die bonding process, the semiconductor chip 26 is fixed to the heat dissipation sheet 24.

In step S16 (Fig. 7), the wire 29 is formed between the circuit board 21 and the semiconductor chip 26 by wire bonding, and the circuit board 21 and the semiconductor chip 26 are electrically connected.

In step S17 and step S18, the bonding of the frame 27 is performed. In step S17, the adhesive 23-2 is applied to the heat dissipation sheet 24. As illustrated in step S17, the adhesive 23-2 is applied to a position where the frame 27 is arranged, specifically to four sides of the peripheral portion 52 of the heat dissipation sheet 24.

In step S18, the frame 27 is mounted on the heat dissipation sheet 24 by being brought into close contact with the region to which the adhesive 23-2 is applied, and the heat treatment is performed to thermally cure the adhesive 23-2. As a result, the frame 27 is fixed.

In step S19, the glass substrate 28 is arranged on the frame 27, and thus, the semiconductor package 10 is sealed.

In such a step, the semiconductor package 10 illustrated in Fig. 1 is manufactured. Note that the manufacturing steps described here are examples, and cases where the order of steps is changed or other steps are added are also within the scope of application of the present technology.

As described above, the semiconductor package 10 is fabricated, and is mounted on a heat dissipation member or a housing inside an imaging device (camera). Thus, it is possible to realize a package that is small, lightweight, and has high heat dissipation while optical accuracy required as a camera is maintained.

According to the present technology, it is possible to realize a semiconductor package that is small, lightweight, and has high heat dissipation capable of suppressing the warpage of the semiconductor chip 26 and the circuit board 21 on which the semiconductor chip 26 is mounted due to the temperature change. Furthermore, for example, due to the use of graphite for the heat dissipation sheet, the graphite attenuates the electromagnetic wave from the circuit board 21, and the electromagnetic wave noise generated between the semiconductor chip 26 and the circuit board 21 can be reduced.

### <Example of Application to Electronic Device>

The present technology can be applied to all electronic devices using an image pickup element in an image capturing unit (photoelectric conversion unit), such as an imaging device like a digital still camera or a video camera, a mobile terminal device having an imaging function, and a copying machine using the image pickup element in an image reading unit. The image pickup element may be formed as one chip, or may be in a modular form having an imaging function in which an imaging section and a signal processing unit or an optical system are packaged together.

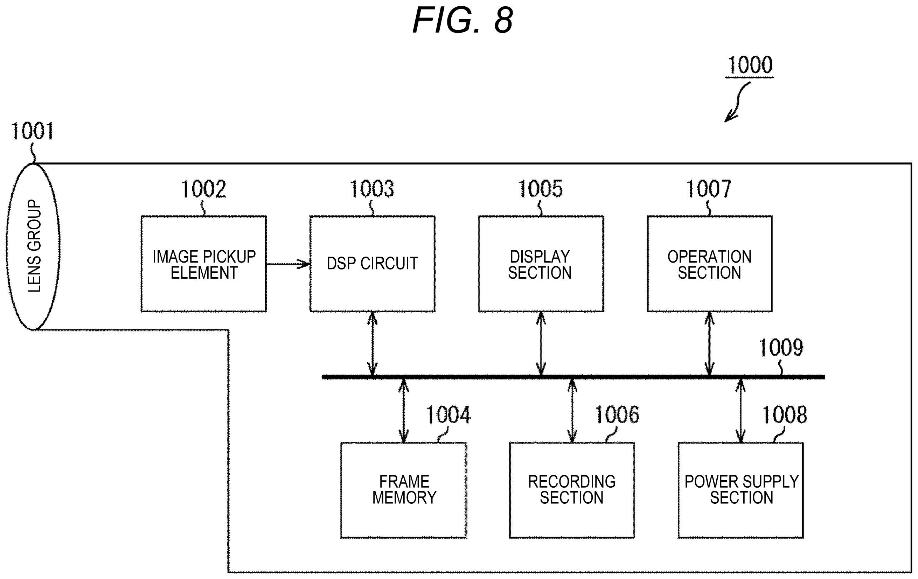

Fig. 8 is a block diagram illustrating a configuration example of an imaging device as an electronic device to which the present technology is applied.

An image pickup element 1000 in Fig. 8 includes an optical unit 1001 including a lens group and the like, an image pickup element (imaging device) 1002, and a digital signal processor (DSP) circuit 1003 that is a camera signal processing circuit. Furthermore, the image pickup element 1000 includes a frame memory 1004, a display section 1005, a recording section 1006, an operation section 1007, and a power supply section 1008. The DSP circuit 1003, the frame memory 1004, the display section 1005, the recording section 1006, the operation section 1007, and the power supply section 1008 are connected to one another via a bus line 1009.

The optical unit 1001 captures incident light (image light) from an object, and forms an image on an imaging surface of the image pickup element 1002. The image pickup element 1002 converts the amount of incident light forming the image on the imaging surface by the optical unit 1001 into an electric signal on a pixel basis, and outputs the electric signal as a pixel signal.

The display section 1005 includes a flat-panel display such as a liquid crystal display (LCD) or an organic electro luminescence (EL) display, for example, and displays a moving image or a still image imaged by the image pickup element 1002. The recording section 1006 records the moving image or the still image imaged by the image pickup element 1002 in a recording medium such as a hard disk or a semiconductor memory.

The operation section 1007 issues operation commands for various functions of the image pickup element 1000 under the operation by a user. The power supply section 1008 appropriately supplies various kinds of power that are operating power supplies for the DSP circuit 1003, the frame memory 1004, the display section 1005, the recording section 1006, and the operation section 1007, to these supply targets.

The semiconductor package 10 including the semiconductor chip 26 described above or below can be applied to a part of the imaging device illustrated in Fig. 8.

### <Second Embodiment>

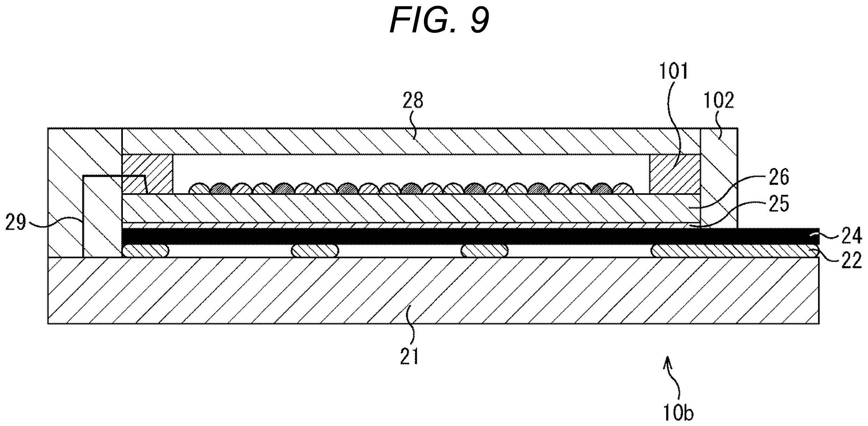

Fig. 9 is a diagram illustrating a configuration of a second embodiment of the semiconductor package to which the present technology is applied. In the following description, the semiconductor package 10 described with reference to Figs. 1 to 8 is referred to as a semiconductor package 10 according to a first embodiment, and is appropriately referred to as a semiconductor package 10a. A semiconductor package 10 according to the second embodiment described with reference to Fig. 9 will be referred to as a semiconductor package 10b.

In the following description, the same portions as those of the semiconductor package 10a according to the first embodiment illustrated in Fig. 1 are denoted by the same reference signs, and the description thereof is appropriately omitted.

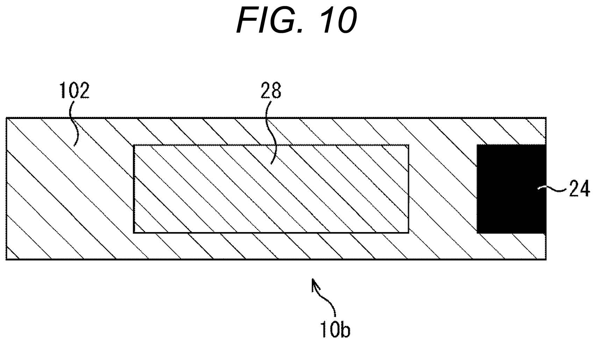

Fig. 9 is a schematic cross-sectional view of the semiconductor package 10b, and Fig. 10 is a plan view of the semiconductor package 10b. In Figs. 9 and 10, the semiconductor package 10b houses and packages a semiconductor chip 26 as the image sensor.

A thermosetting resin 22 is arranged on a circuit board 21 of the semiconductor package 10b. A heat dissipation sheet 24 is arranged on the thermosetting resin 22. The semiconductor chip 26 is arranged on an upper surface side of the heat dissipation sheet 24 via a thermosetting resin 25.

The thermosetting resin 22 is provided between the heat dissipation sheet 24 and the circuit board 21. The thermosetting resin 22 functions as an adhesive for bonding the heat dissipation sheet 24 and the circuit board 21, and also functions as a holding portion for supporting the semiconductor chip 26 arranged on the heat dissipation sheet 24. The thermosetting resin 22 is provided in a shape having a plurality of voids (in Fig. 9, three). The thermosetting resin 22 is provided such that a space surrounded by the circuit board 21, the heat dissipation sheet 24, and the thermosetting resin 22 is present between the circuit board 21 and the heat dissipation sheet 24.

The heat dissipation sheet 24 is fixed in a state of being sandwiched between the circuit board 21 and the semiconductor chip 26. The heat dissipation sheet 24 absorbs and conducts heat generated in the semiconductor chip 26 and releases the heat to an outside of the semiconductor package 10b. The heat dissipation sheet 24 is drawn out to the outside of the semiconductor package 10b in the planar direction (in Fig. 9, right direction), and the heat dissipation member is connected to a housing not illustrated. Note that a direction in which the heat dissipation sheet 24 is drawn out is appropriately changed according to the structure of a camera or the like on which the semiconductor package 10b is mounted. Furthermore, a plurality of portions may be drawn out instead of one portion.

As the heat dissipation sheet 24, a thin flexible graphite sheet having high thermal conductivity, a sheet containing metal or ceramic, for example, a copper foil sheet, an aluminum foil sheet, or the like is used.

Electrodes of the semiconductor chip 26 and electrodes of the circuit board 21 are connected by a wire 29, and a signal obtained in the semiconductor chip 26 is supplied to a circuit of the circuit board 21 and processed. The wire 29 is enclosed in a glass holding portion 101 and a molding resin 102, and is provided in a state of being fixed in the glass holding portion 101 and the molding resin 102.

The thermosetting resin 25 is provided between the heat dissipation sheet 24 and the semiconductor chip 26. The thermosetting resin 25 functions as an adhesive for bonding the heat dissipation sheet 24 and the semiconductor chip 26, and also has a function of efficiently conducting heat generated in the semiconductor chip 26 to the heat dissipation sheet 24.

The thermosetting resin 22 is provided on the lower surface side (lower side in the drawing) of the heat dissipation sheet 24, and the thermosetting resin 25 is provided on the upper surface side (upper side in the drawing). The thermosetting resin 22 and the thermosetting resin 25 are formed by using materials having different characteristics. The thermosetting resin 22 provided on the circuit board 21 side is a thermosetting resin having a low elastic modulus, and for example, a resin having an elastic modulus of about 5 MPa to 500 MPa is used. The thermosetting resin 25 provided on the semiconductor chip 26 side is a thermosetting resin having a small linear expansion coefficient, a high elastic modulus, and high thermal conductivity, and for example, a resin having an elastic modulus of about 500 MPa to 1 GPa is used.

As described above, different materials are used above and below the heat dissipation sheet 24, and thus, it is possible to prevent the circuit board 21 and the semiconductor chip 26 from being warped. In a case where the thermosetting resin 22 and the thermosetting resin 25 are formed by using the same material, there is a possibility that the circuit board 21 and the semiconductor chip 26 are warped when a temperature changes due to a difference in linear expansion coefficient between the circuit board 21 and the semiconductor chip 26.

The thermosetting resin 22 and the thermosetting resin 25 are formed by using different materials, and it is possible to suppress the influence of fluctuations in the warpage occurring in the circuit board 21 and the semiconductor chip 26 when the temperature changes.

The semiconductor chip 26 is surrounded by the molding resin 102, and the semiconductor chip 26 is enclosed in a space surrounded by the molding resin 102. The glass holding portion 101 is provided inside the molding resin 102, and the glass substrate 28 is held by the glass holding portion 101.

The glass holding portion 101 is an outer peripheral region of the semiconductor chip 26, and is formed on a region of the semiconductor chip 26 where the image pickup element is not provided. The glass substrate 28 is arranged on the glass holding portion 101. The glass holding portion 101 is formed by using a predetermined resin. A region of the semiconductor chip 26 where the image pickup element is arranged is in a state of being sealed by the semiconductor chip 26, the glass holding portion 101, and the glass substrate 28.

The molding resin 102 is provided outside the semiconductor chip 26, the molding resin 102 positioned on a left side in the drawing is provided on the circuit board 21, and the molding resin 102 positioned on a right side in the drawing is provided on the heat dissipation sheet 24. The semiconductor chip 26 is in a state of being sealed by the circuit board 21, the molding resin 102, and the glass substrate 28.

As illustrated in Fig. 10, in a case where the semiconductor package 10b is viewed from the glass substrate 28 side, the molding resin 102 is provided so as to surround the glass substrate 28. Furthermore, a region where the heat dissipation sheet 24 is provided in an exposed state is provided in a part (right side in the drawing) of the molding resin 102. The heat dissipation sheet 24 is exposed, and thus, the heat generated in the semiconductor chip 26 can be released to the outside of the semiconductor package 10b.

### <About Manufacturing of Semiconductor Package 10b>

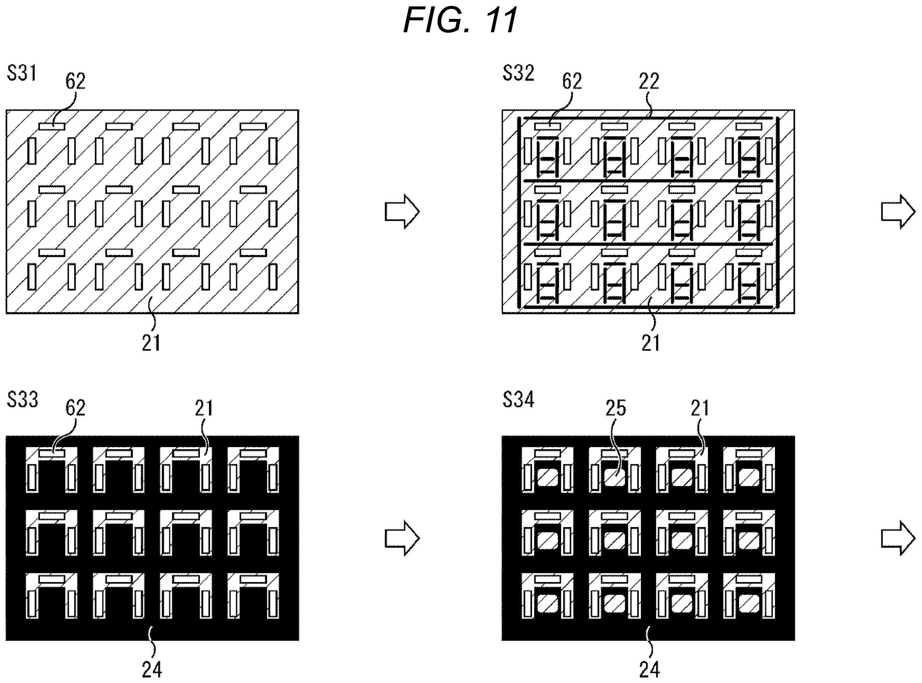

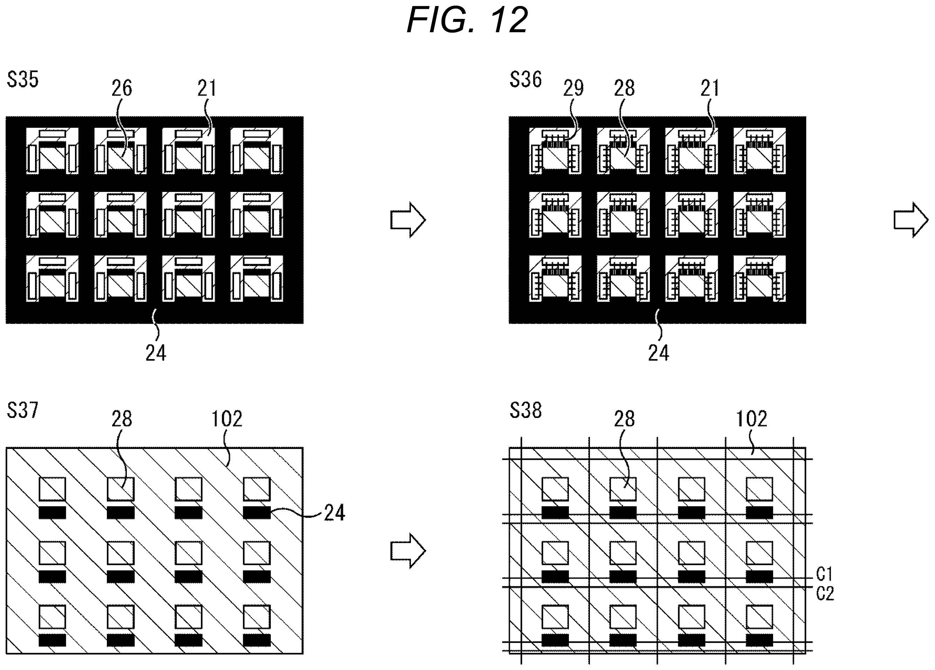

The manufacturing of the semiconductor package 10b illustrated in Fig. 9 will be described with reference to Figs. 11 and 12.

In step S31 to step S33, the attachment of the heat dissipation sheet 24 is performed. In step S31, the circuit board 21 on which a circuit is formed is prepared. A plurality of quadrangles on the circuit board 21 illustrated in step S31 indicates regions (hereinafter, referred to as lead regions 62) in which electrodes (inner leads 61) to be wire-bonded are arranged.

The circuit board 21 prepared in step S31 is an organic collective board, and a plurality of circuit boards 21 is formed on one wafer. The example illustrated in Fig. 11 illustrates an example in which 12 circuit boards 21 of 3 × 4 are arranged on one wafer. The example illustrated in Fig. 11 illustrates an example in which the lead regions 62 are provided on three sides of one circuit board 21.

In step S32, the thermosetting resin 22 is applied to the circuit boards 21. As illustrated in step S32, the thermosetting resin 22 is applied to a position where the semiconductor chip 26 is arranged, specifically to an inner side where the lead regions 62 are arranged and to an outer side of one side where the lead region 62 is not arranged. Furthermore, the thermosetting resin 22 is also applied to four sides of an outer peripheral portion of the wafer and also between the circuit boards 21. Note that an application pattern of the thermosetting resin 22 illustrated in Fig. 11 is an example, and may be another application pattern, for example, may be solid coating.

In step S33, the heat dissipation sheet 24 is brought into close contact with the circuit board 21 to which the thermosetting resin 22 is applied, and heating is performed to cure the thermosetting resin 22. The heat dissipation sheet 24 has a shape in which the lead regions 62 are opened. In a case where attention is paid to one circuit board 21, the heat dissipation sheet 24 covering a region of the four sides (outer peripheral portion) of the circuit board 21, a region of the center, and a region (a region on the lower side in the drawing) connected from the region of the center to the region of the outer peripheral portion is attached to the circuit board 21.

In step S34 and step S35 (Fig. 12), die bonding is performed. In step S34, the thermosetting resin 25 is applied to the entire surface of a region of the heat dissipation sheet 24 where the semiconductor chip 26 is arranged.

In step S35 (Fig. 12), the semiconductor chip 26 is mounted on the heat dissipation sheet 24 by being brought into close contact with the region to which thermosetting resin 25 is applied, and heat treatment is performed to thermally cure the thermosetting resin 25. By such a die bonding process, the semiconductor chip 26 is fixed to the heat dissipation sheet 24.

In step S36, the wire 29 is formed between the circuit board 21 and the semiconductor chip 26 by wire bonding, and the circuit board 21 and the semiconductor chip 26 are electrically connected. After the wire bonding, the glass holding portion 101 is formed on the four sides of the outer peripheral portion of the semiconductor chip 26 avoiding the image pickup element, and the glass substrate 28 is bonded thereon.

In step S37, molding is performed. The molding is performed by using a mold protected such that the molding resin 102 is not poured into a part of the glass substrate 28 and the heat dissipation sheet 24. In step S37, resin-sealing of the semiconductor chip 26 is performed by pouring the molding resin 102 into a region other than a part of the glass substrate 28 and the heat dissipation sheet 24.

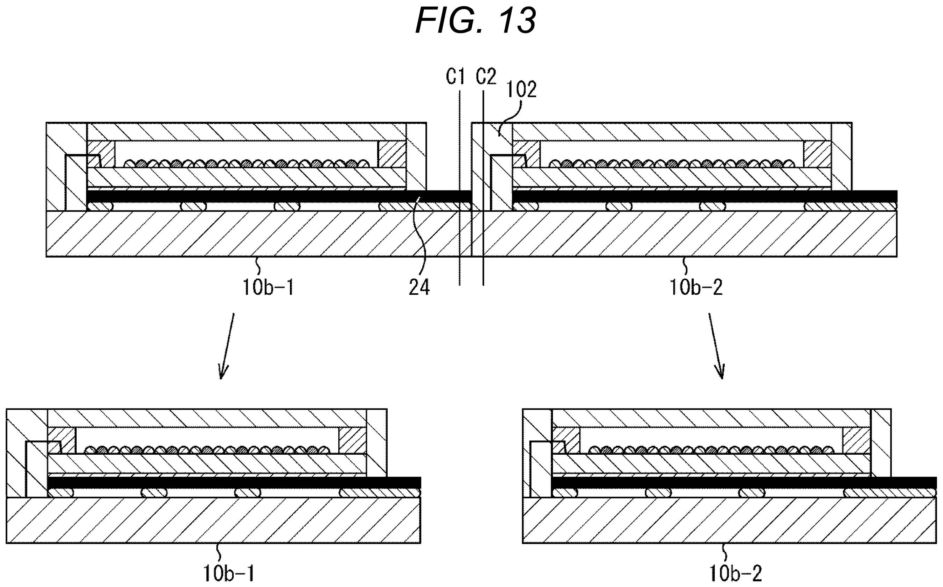

In step S38, the singulation of the semiconductor package 10b is performed. In the drawing, cutting is performed once in a longitudinal direction, and cutting is performed twice in a lateral direction. Thus, the singulation is performed. For example, cutting is performed along a cut line C1, and then cutting is performed along a cut line C2. Such cutting performed twice will be described with reference to Fig. 13.

An upper drawing of Fig. 13 illustrates two semiconductor packages 10b-1 and 10b-2 on the wafer before cutting. The semiconductor package 10b-1 and the semiconductor package 10b-2 are cut along the cut lines C1 and C2, and thus, the semiconductor package 10b-1 and the semiconductor package 10b-2 are singulated as illustrated in a lower drawing of Fig. 13.

The cut line C1 is positioned on the exposed heat dissipation sheet 24 of the semiconductor package 10b-1, and the cut line C2 is positioned on the molding resin 102 of the semiconductor package 10b-2.

In a case where the singulation is performed by being cut only once at the cut line C1 and singulated, the singulation is performed in a state where the exposed heat dissipation sheet 24 of the semiconductor package 10b-1 remains in the semiconductor package 10b-2. In a case where singulation is performed by being cut only once at the cut line C2, the singulation is performed in a state where the molding resin 102 of the semiconductor package 10b-2 remains in the semiconductor package 10b-1.

In a case where the singulation is performed by being cut only one of the cut line C1 and the cut line C2, there is a possibility that the singulation is performed in a state where the extra heat dissipation sheet 24 or molding resin 102 remains. As illustrated in Fig. 13, cutting is performed twice along the cut line C1 and the cut line C2, and thus, the singulation can be performed without the remaining extra heat dissipation sheet 24 or molding resin 102.

Here, the description will be continued on the assumption that the cutting is performed twice. However, in a case where the extra heat dissipation sheet 24 or molding resin 102 may remain, for example, in a case where processing of removing the extra heat dissipation sheet 24 or molding resin 102 is performed in subsequent processing, or in a case where there is no problem even though the extra heat dissipation sheet or molding resin remains, the singulation may be performed by one cutting. Furthermore, in a case where cutting accuracy at the time of singulation is high and the cutting can be performed at a position where the extra heat dissipation sheet 24 or molding resin 102 does not remain, the singulation may be performed by one cutting.

In such a step, the semiconductor package 10b illustrated in Fig. 9 is manufactured. Note that the manufacturing steps described here are examples, and cases where the order of steps is changed or other steps are added are also within the scope of application of the present technology.

As described above, the semiconductor package 10b is fabricated, and is mounted on a heat dissipation member or a housing inside an imaging device (camera). Thus, it is possible to realize a package that is small, lightweight, and has high heat dissipation while optical accuracy required as a camera is maintained.

According to the present technology, it is possible to realize a semiconductor package that is small, lightweight, and has high heat dissipation capable of suppressing the warpage of the semiconductor chip 26 and the circuit board 21 on which the semiconductor chip 26 is mounted due to the temperature change. Furthermore, for example, due to the use of graphite for the heat dissipation sheet, the graphite attenuates the electromagnetic wave from the circuit board 21, and the electromagnetic wave noise generated between the semiconductor chip 26 and the circuit board 21 can be reduced.

### <About Another Manufacturing of Semiconductor Package 10b>

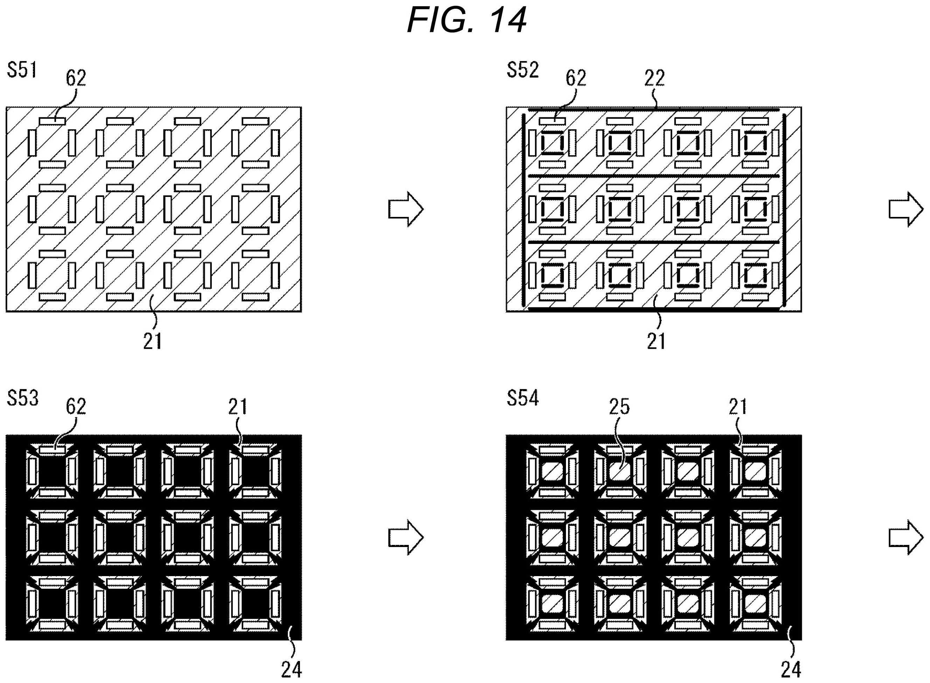

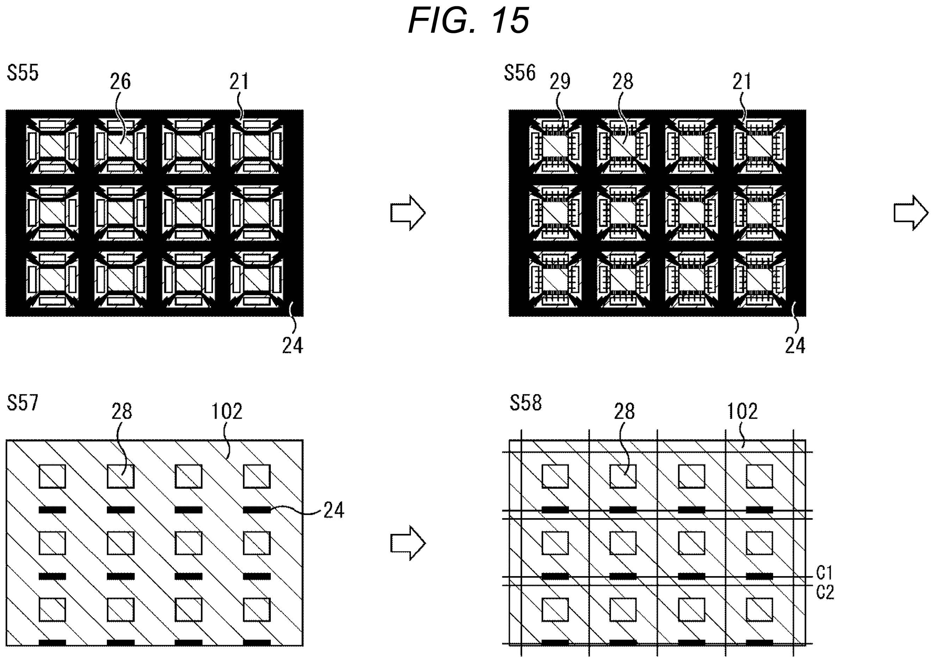

Another manufacturing of the semiconductor package 10b illustrated in Fig. 9 will be described with reference to Figs. 14 and 15. Another manufacturing of the semiconductor package 10b described with reference to Figs. 14 and 15 is different from the manufacturing of the semiconductor package 10b described with reference to Figs. 11 and 12 in that the lead regions 62 provided in the circuit board 21 are provided on the four sides and the shape of the heat dissipation sheet 24 to be attached is different as the lead regions are provided on the four sides, but a flow of basic manufacturing steps is the same. Description of the same steps will be omitted as appropriate.

In step S51, an organic collective board having a plurality of circuit boards 21 formed on one wafer is prepared. The example illustrated in Fig. 14 illustrates an example in which 12 circuit boards 21 of 3 × 4 are arranged on one wafer. The example illustrated in Fig. 14 illustrates an example in which the lead regions 62 are provided on the four sides of one circuit board 21. This configuration is similar to that of the semiconductor package 10a according to the first embodiment.

In step S52, the thermosetting resin 22 is applied to the circuit boards 21. As illustrated in step S52, the thermosetting resin 22 is applied to a position where the semiconductor chip 26 is arranged, specifically to an inner side where the lead regions 62 are arranged. Furthermore, the thermosetting resin 22 is also applied to four sides of an outer peripheral portion of the wafer and also between the circuit boards 21. Note that an application pattern of the thermosetting resin 22 illustrated in Fig. 14 is an example, and may be another application pattern, for example, may be solid coating.

In step S53, the heat dissipation sheet 24 is brought into close contact with the circuit board 21 on which the thermosetting resin 22 is applied, and heating is performed to cure the thermosetting resin 22. The heat dissipation sheet 24 has a shape in which the lead regions 62 are opened. In the example illustrated in Fig. 14, since the lead regions 62 are provided at four locations, the heat dissipation sheet 24 having a shape opened at four locations is attached to the circuit board 21. The heat dissipation sheet 24 attached to one circuit board 21 has the same shape as the heat dissipation sheet 24 according to the first embodiment, for example, the heat dissipation sheet 24 described with reference to Figs. 2 to 4. That is, connecting portions 53 each having a curved portion 71 and a straight portion 72 are provided at four corners of the heat dissipation sheet 24.

Note that, in step S33 described with reference to Fig. 11, the heat dissipation sheet 24 in which the connecting portion 53 is formed on each of the upper left and the upper right can be used as the shape of the heat dissipation sheet 24 attached to the circuit board 21.

In the heat dissipation sheet 24 attached to the circuit board 21 in step S33 described with reference to Fig. 11, since the heat dissipation sheet 24 at a portion connecting the heat dissipation sheet 24 positioned on a lower surface of the semiconductor chip 26 and the heat dissipation sheet 24 exposed to an outside of the semiconductor package 10b is formed to be wide, heat dissipation performance can be enhanced. There is a possibility that the heat dissipation sheet 24 attached to the circuit board 21 in step S53 described with reference to Fig. 14 has lower heat dissipation performance than the heat dissipation sheet 24 exposed to the outside of the semiconductor package 10b, but performance of alleviating stress can be improved.

Whether to use the heat dissipation sheet 24 illustrated in Fig. 11 or the heat dissipation sheet 24 illustrated in Fig. 14 is based on the number and positions of the lead regions 62 provided on the circuit board 21, but it is also possible to select which to use depending on whether to prioritize the heat dissipation performance or the stress alleviating performance.

In step S54 and step S55 (Fig. 15), die bonding is performed. Since processing in and after step S54 is basically similar to the processing in and after step S34 (Fig. 12), the description thereof will be omitted.

In such a step, the semiconductor package 10b illustrated in Fig. 9 is manufactured. Note that the manufacturing steps described here are examples, and cases where the order of steps is changed or other steps are added are also within the scope of application of the present technology.

As described above, the semiconductor package 10b is fabricated, and is mounted on a heat dissipation member or a housing inside an imaging device (camera). Thus, it is possible to realize a package that is small, lightweight, and has high heat dissipation while optical accuracy required as a camera is maintained.

According to the present technology, it is possible to realize a semiconductor package that is small, lightweight, and has high heat dissipation capable of suppressing the warpage of the semiconductor chip 26 and the circuit board 21 on which the semiconductor chip 26 is mounted due to the temperature change. Furthermore, for example, due to the use of graphite for the heat dissipation sheet, the graphite attenuates the electromagnetic wave from the circuit board 21, and the electromagnetic wave noise generated between the semiconductor chip 26 and the circuit board 21 can be reduced.

### <Third Embodiment>

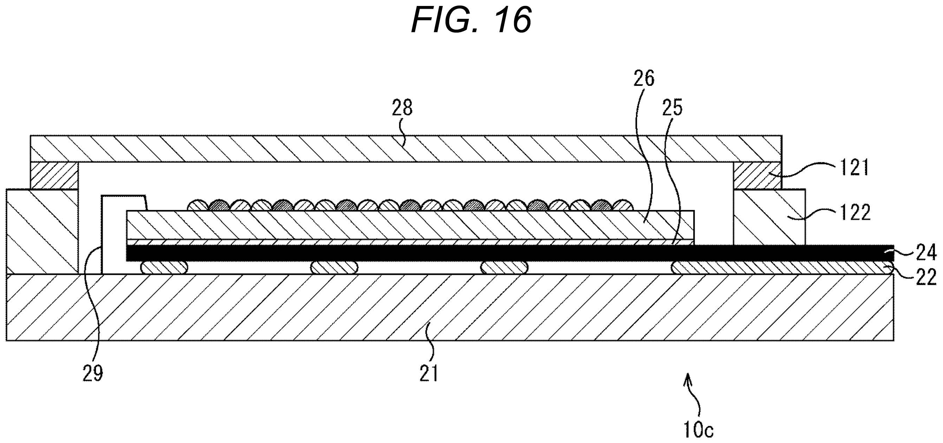

Fig. 16 is a diagram illustrating a configuration of a third embodiment of the semiconductor package 10 to which the present technology is applied. A semiconductor package 10 according to the third embodiment described with reference to Fig. 16 will be referred to as a semiconductor package 10c.

Fig. 16 is a schematic cross-sectional view of the semiconductor package 10c. In Fig. 16, the semiconductor package 10c houses and packages a semiconductor chip 26 as an image sensor.

A thermosetting resin 22 is arranged on a circuit board 21 of the semiconductor package 10. A heat dissipation sheet 24 is arranged on the thermosetting resin 22. The semiconductor chip 26 is arranged on an upper surface side of the heat dissipation sheet 24 via a thermosetting resin 25.

The thermosetting resin 22 is provided between the heat dissipation sheet 24 and the circuit board 21. The thermosetting resin 22 functions as an adhesive for bonding the heat dissipation sheet 24 and the circuit board 21, and also functions as a holding portion for supporting the semiconductor chip 26 arranged on the heat dissipation sheet 24. The thermosetting resin 22 is provided in a shape having a plurality of voids (in Fig. 16, three). The thermosetting resin 22 is provided such that a space surrounded by the circuit board 21, the heat dissipation sheet 24, and the thermosetting resin 22 is present between the circuit board 21 and the heat dissipation sheet 24.

The heat dissipation sheet 24 is fixed in a state of being sandwiched between the circuit board 21 and the semiconductor chip 26. The heat dissipation sheet 24 absorbs and conducts heat generated in the semiconductor chip 26 and releases the heat to an outside of the semiconductor package 10c. The heat dissipation sheet 24 is drawn out to the outside of the semiconductor package 10c in a planar direction (in Fig. 16, right direction), and the heat dissipation member is connected to a housing not illustrated. Note that a direction in which the heat dissipation sheet 24 is drawn out is appropriately changed according to the structure of a camera or the like on which the semiconductor package 10c is mounted. Furthermore, a plurality of portions may be drawn out instead of one portion.

As the heat dissipation sheet 24, a thin flexible graphite sheet having high thermal conductivity, a sheet containing metal or ceramic, for example, a copper foil sheet, an aluminum foil sheet, or the like is used.

Electrodes of the semiconductor chip 26 and electrodes of the circuit board 21 are connected by a wire 29, and a signal obtained in the semiconductor chip 26 is supplied to a circuit of the circuit board 21 and processed.

The thermosetting resin 25 is provided between the heat dissipation sheet 24 and the semiconductor chip 26. The thermosetting resin 25 functions as an adhesive for bonding the heat dissipation sheet 24 and the semiconductor chip 26, and also has a function of efficiently conducting heat generated in the semiconductor chip 26 to the heat dissipation sheet 24.

The thermosetting resin 22 is provided on the lower surface side (lower side in the drawing) of the heat dissipation sheet 24, and the thermosetting resin 25 is provided on the upper surface side (upper side in the drawing). The thermosetting resin 22 and the thermosetting resin 25 are formed by using materials having different characteristics. The thermosetting resin 22 provided on the circuit board 21 side is a thermosetting resin having a low elastic modulus, and for example, a resin having an elastic modulus of about 5 MPa to 500 MPa is used. The thermosetting resin 25 provided on the semiconductor chip 26 side is a thermosetting resin having a small linear expansion coefficient, a high elastic modulus, and high thermal conductivity, and for example, a resin having an elastic modulus of about 500 MPa to 1 GPa is used.

As described above, different materials are used above and below the heat dissipation sheet 24, and thus, it is possible to prevent the circuit board 21 and the semiconductor chip 26 from being warped.

The semiconductor chip 26 is surrounded by a molding resin 122, and the semiconductor chip 26 is enclosed in a space formed by the molding resin 122. A side surface of the semiconductor chip 26 and a side surface of the molding resin 122 are provided at distant positions, and are provided so as to have a space. A wire 29 is provided in the space between the side surface of the semiconductor chip 26 and the side surface of the molding resin 122.

A glass holding portion 121 is provided on an upper side of the molding resin 122 in the drawing, and a glass substrate 28 is held (bonded) by the glass holding portion 121. The semiconductor chip 26 is in a state of being sealed by the circuit board 21, the molding resin 122, the glass holding portion 121, and the glass substrate 28.

### <About Manufacturing of Semiconductor Package 10c>

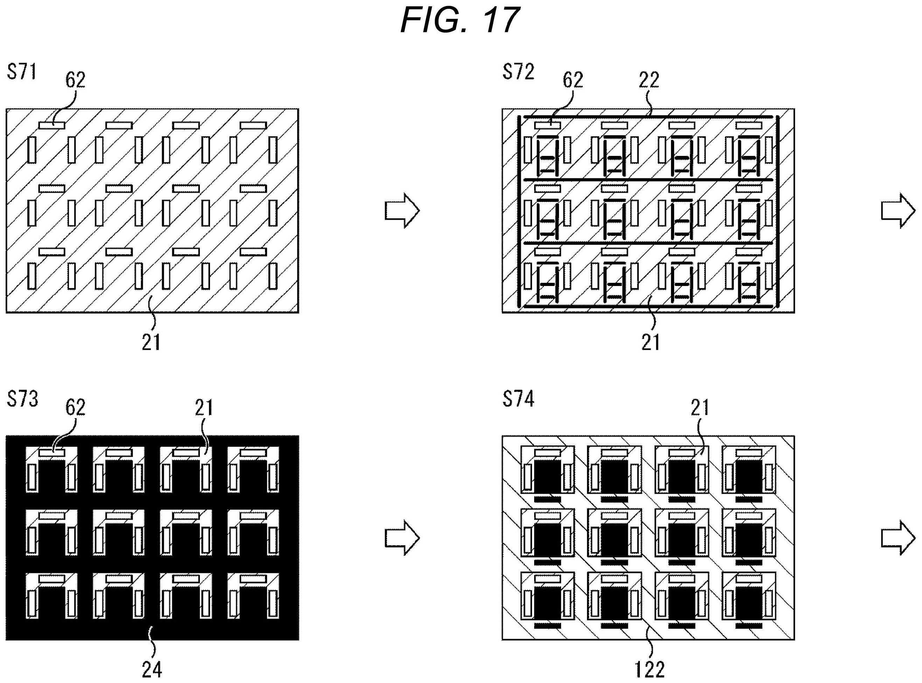

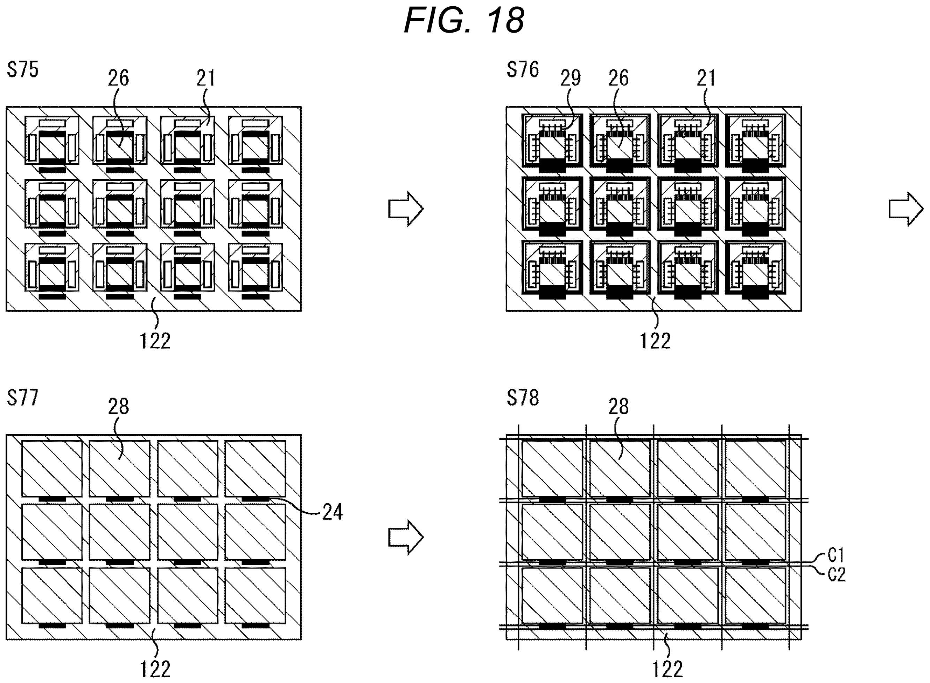

The manufacturing of the semiconductor package 10c illustrated in Fig. 16 will be described with reference to Figs. 17 and 18.

In step S71, the circuit board 21 on which a circuit is formed is prepared. Three lead regions 62 are provided in the circuit board 21 illustrated in step S71. In step S71, an organic collective board having a plurality of circuit boards 21 formed on one wafer is prepared.

In step S72, the thermosetting resin 22 is applied to the circuit boards 21. As illustrated in step S72, the thermosetting resin 22 is applied to a position where the semiconductor chip 26 is arranged, specifically to an inner side where the lead regions 62 are arranged and to an outer side of one side where the lead region 62 is not arranged. Furthermore, the thermosetting resin 22 is also applied to four sides of an outer peripheral portion of the wafer and also between the circuit boards 21. Note that an application pattern of the thermosetting resin 22 illustrated in Fig. 17 is an example, and may be another application pattern, for example, may be solid coating.

In step S73, the heat dissipation sheet 24 is brought into close contact with the circuit board 21 on which the thermosetting resin 22 is applied, and heating is performed to cure the thermosetting resin 22. The heat dissipation sheet 24 has a shape in which the lead regions 62 are opened. In a case where attention is paid to one circuit board 21, the heat dissipation sheet 24 covering a region of the four sides (outer peripheral portion) of the circuit board 21, a region of the center, and a region (a region on the lower side in the drawing) connected from the region of the center to the region of the outer peripheral portion is attached to the circuit board 21.

In step S74, molding is performed. The molding is performed by using a mold protected such that the molding resin 122 is not poured into a region including the region where the semiconductor chip 26 is arranged and the region where the lead regions 62 are provided and a part of the heat dissipation sheet 24.

In step S75 (Fig. 18), die bonding is performed. In step S75, the thermosetting resin 25 is applied to the entire surface of the region of the heat dissipation sheet 24 where the semiconductor chip 26 is arranged, the semiconductor chip 26 is mounted on the heat dissipation sheet 24 by bringing the semiconductor chip 26 into close contact with the region to which the thermosetting resin 25 is applied, and the thermosetting resin 25 is thermally cured by performing heat treatment. By such a die bonding process, the semiconductor chip 26 is fixed to the heat dissipation sheet 24.

In step S76, the wire 29 is formed between the circuit board 21 and the semiconductor chip 26 by wire bonding, and the circuit board 21 and the semiconductor chip 26 are electrically connected. After the wire bonding, the glass holding portion 121 is formed on the molding resin 122.

In step S77, the glass substrate 28 is bonded to the formed glass holding portion 121.

In step S78, the singulation of the semiconductor package 10c is performed. In a lateral direction in the drawing, cutting is performed along a cut line C1, and then cutting is performed along a cut line C2. Cutting is performed twice in this manner, and thus, the singulation is performed. Note that the reason why cutting is performed twice has been described with reference to step S38 (Fig. 12) and Fig. 13, and thus, the description thereof is omitted here. Furthermore, it is possible to apply a step of singulating by one cutting.

In such a step, the semiconductor package 10c illustrated in Fig. 16 is manufactured. Note that the manufacturing steps described here are examples, and cases where the order of steps is changed or other steps are added are also within the scope of application of the present technology.

As described above, the semiconductor package 10c is fabricated, and is mounted on a heat dissipation member or a housing inside an imaging device (camera). Thus, it is possible to realize a package that is small, lightweight, and has high heat dissipation while optical accuracy required as a camera is maintained.

According to the present technology, it is possible to realize a semiconductor package that is small, lightweight, and has high heat dissipation capable of suppressing the warpage of the semiconductor chip 26 and the circuit board 21 on which the semiconductor chip 26 is mounted due to the temperature change. Furthermore, for example, due to the use of graphite for the heat dissipation sheet, the graphite attenuates the electromagnetic wave from the circuit board 21, and the electromagnetic wave noise generated between the semiconductor chip 26 and the circuit board 21 can be reduced.

### <About Other Manufacturing of Semiconductor Package 10c>

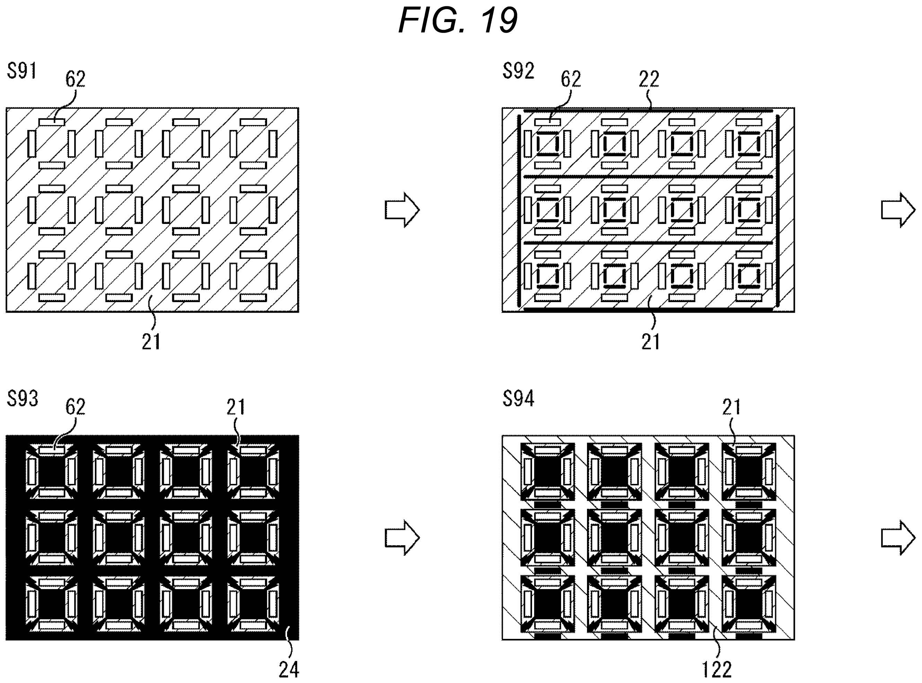

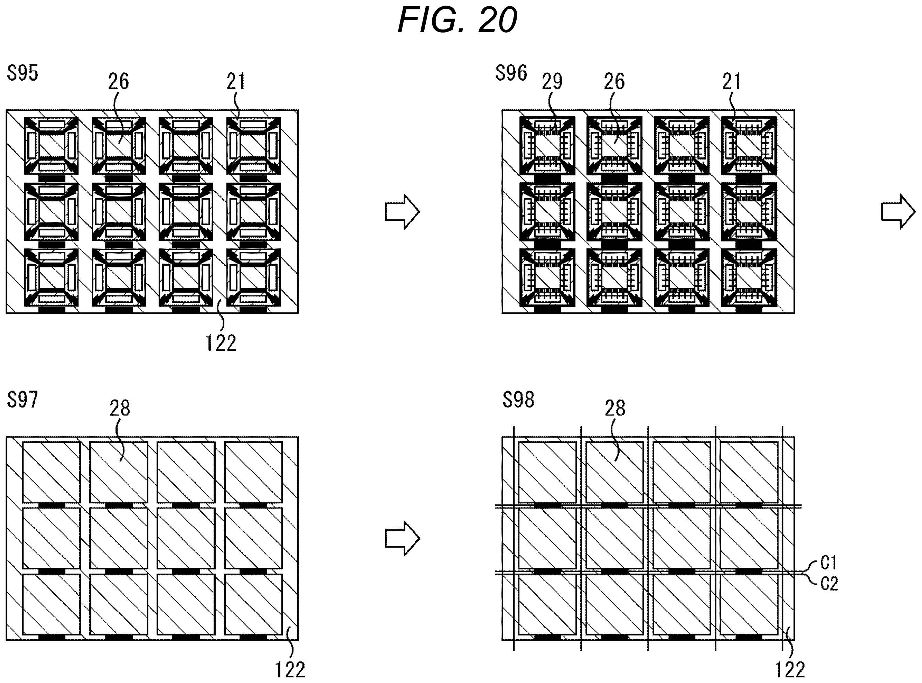

Another manufacturing of the semiconductor package 10c illustrated in Fig. 16 will be described with reference to Figs. 19 and 20. Another manufacturing of the semiconductor package 10c described with reference to Figs. 19 and 20 is different from the manufacturing of the semiconductor package 10c described with reference to Figs. 17 and 18 in that the lead regions 62 provided in the circuit board 21 are provided on the four sides and the shape of the heat dissipation sheet 24 to be attached is different as the lead regions are provided on the four sides, but a flow of basic manufacturing step is the same. Description of the same steps will be omitted as appropriate.

In step S91, an organic collective board having a plurality of circuit boards 21 formed on one wafer is prepared. The example illustrated in Fig. 19 illustrates an example in which 12 circuit boards 21 of 3 × 4 are arranged on one wafer. In the example illustrated in Fig. 19, an example in which the lead regions 62 are provided on the four sides of one circuit board 21 is illustrated. This configuration is similar to that of the semiconductor package 10a according to the first embodiment.

In step S92, the thermosetting resin 22 is applied to the circuit boards 21. As illustrated in step S92, the thermosetting resin 22 is applied in a quadrangular shape to a position where the semiconductor chip 26 is arranged, specifically to an inner side where the lead regions 62 are arranged. Furthermore, the thermosetting resin 22 is also applied to four sides of an outer peripheral portion of the wafer and also between the circuit boards 21. Note that an application pattern of the thermosetting resin 22 illustrated in Fig. 19 is an example, and may be another application pattern, for example, may be solid coating.

In step S93, the heat dissipation sheet 24 is brought into close contact with the circuit board 21 on which the thermosetting resin 22 is applied, heating is performed, and the thermosetting resin 22 is cured. The heat dissipation sheet 24 has a shape in which the lead regions 62 are opened. In the example illustrated in Fig. 19, since the lead regions 62 are provided at four locations, the heat dissipation sheet 24 having a shape opened at four locations is attached to the circuit board 21. The heat dissipation sheet 24 attached to one circuit board 21 has the same shape as the heat dissipation sheet 24 according to the first embodiment, for example, the heat dissipation sheet 24 described with reference to Figs. 2 to 4. That is, connecting portions 53 each having a curved portion 71 and a straight portion 72 are provided at four corners of the heat dissipation sheet 24.

Note that, as the shape of the heat dissipation sheet 24 attached to the circuit board 21 in step S73 described with reference to Fig. 17, the heat dissipation sheet 24 in which the connecting portion 53 is formed on each of the upper left and the upper right can be used.

Whether to use the heat dissipation sheet 24 illustrated in Fig. 17 or the heat dissipation sheet 24 illustrated in Fig. 19 is based on the number and position of the lead regions 62 provided on the circuit board 21, but it is also possible to select which to use depending on whether to prioritize heat dissipation performance or stress alleviating performance.

In step S94, molding is performed. Since processing in and after step S94 is basically similar to the processing in and after step S74 (Fig. 18), the description thereof will be omitted.

In such a step, the semiconductor package 10c illustrated in Fig. 16 is manufactured. Note that the manufacturing steps described here are examples, and cases where the order of steps is changed or other steps are added are also within the scope of application of the present technology.

As described above, the semiconductor package 10c is fabricated, and is mounted on a heat dissipation member or a housing inside an imaging device (camera). Thus, it is possible to realize a package that is small, lightweight, and has high heat dissipation while optical accuracy required as a camera is maintained.

According to the present technology, it is possible to realize a semiconductor package that is small, lightweight, and has high heat dissipation capable of suppressing the warpage of the semiconductor chip 26 and the circuit board 21 on which the semiconductor chip 26 is mounted due to the temperature change. Furthermore, for example, due to the use of graphite for the heat dissipation sheet, the graphite attenuates the electromagnetic wave from the circuit board 21, and the electromagnetic wave noise generated between the semiconductor chip 26 and the circuit board 21 can be reduced.

### <Fourth Embodiment>

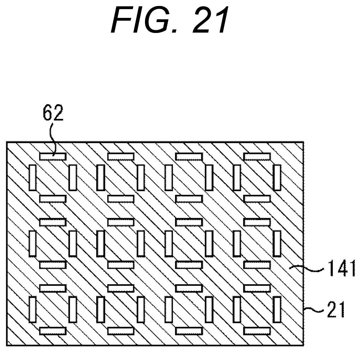

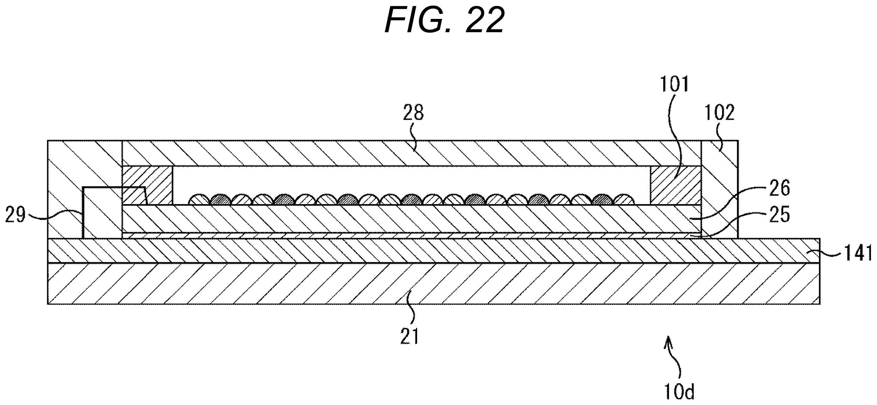

Figs. 21 and 22 are diagrams illustrating a configuration example according to a fourth embodiment of the semiconductor package to which the present technology is applied. A semiconductor package 10 according to the fourth embodiment described with reference to Figs. 21 and 22 will be referred to as a semiconductor package 10d.

As illustrated in Fig. 21, the semiconductor package 10d according to the fourth embodiment is different from the semiconductor packages 10 according to the first to third embodiments in that a circuit board 21 in which a heat dissipation sheet 141 using a resin material having low elasticity and high thermal conductivity is patterned on a front surface of the circuit board 21 is used on an organic collective board prepared at the time of manufacturing.

Fig. 21 illustrates an organic collective board (wafer) prepared at the time of manufacturing, for example, in step S31 (Fig. 11). A plurality of circuit boards 21 is formed on the organic collective board. The heat dissipation sheet 141 formed by using a resin material having low elasticity and high thermal conductivity is formed on front surfaces of the plurality of circuit boards 21 (outermost surface of the organic collective board). The heat dissipation sheet 141 has functions of the thermosetting resin 22 and the heat dissipation sheet 24 included in the semiconductor packages 10 according to the first to third embodiments. That is, the heat dissipation sheet 141 is formed by using a resin material having a function of alleviating the stress of the thermosetting resin 22 and having a function of efficiently dissipating heat of the heat dissipation sheet 24.

In Fig. 21, the circuit board 21 in which the lead regions 62 are provided at four locations is described as an example, but the fourth embodiment can be applied to the circuit board 21 in which the lead regions 62 are provided at three locations, two locations, or one location.

The semiconductor package 10d manufactured by using the circuit board 21 illustrated in Fig. 21 has a cross-sectional configuration as illustrated in Fig. 22. Fig. 22 is a schematic cross-sectional view of the semiconductor package 10d. In Fig. 22, the semiconductor package 10d houses and packages a semiconductor chip 26 as an image sensor.

The heat dissipation sheet 141 formed by using a resin material having low elasticity and high thermal conductivity is arranged on the circuit board 21 of the semiconductor package 10. The semiconductor chip 26 is arranged on an upper surface side of the heat dissipation sheet 141 via a thermosetting resin 25.

The heat dissipation sheet 141 is fixed in a state of being sandwiched between the circuit board 21 and the semiconductor chip 26. The heat dissipation sheet 141 absorbs and conducts heat generated in the semiconductor chip 26 and releases the heat to an outside of the semiconductor package 10d. The heat dissipation sheet 141 is drawn out to the outside of the semiconductor package 10d in a planar direction (in Fig. 22, right direction), and the heat dissipation member is connected to a housing not illustrated. Note that a direction in which the heat dissipation sheet 141 is drawn out is appropriately changed according to the structure of a camera or the like on which the semiconductor package 10d is mounted. Furthermore, a plurality of portions may be drawn out instead of one portion.

Electrodes of the semiconductor chip 26 and electrodes of the circuit board 21 are connected by a wire 29, and a signal obtained in the semiconductor chip 26 is supplied to a circuit of the circuit board 21 and processed. The semiconductor package 10d illustrated in Fig. 22 has a configuration similar to the semiconductor package 10b illustrated in Fig. 9, and the wire 29 is enclosed in a glass holding portion 101 and the molding resin 102. Although not illustrated, the semiconductor package 10d may have a configuration similar to the semiconductor package 10c illustrated in Fig. 16, and the wire 29 may be positioned in a space provided on a side surface of the semiconductor chip 26 and a side surface of a molding resin 122.

The thermosetting resin 25 is provided between the heat dissipation sheet 141 and the semiconductor chip 26. The thermosetting resin 25 functions as an adhesive for bonding the heat dissipation sheet 141 and the semiconductor chip 26, and also has a function of efficiently conducting heat generated in the semiconductor chip 26 to the heat dissipation sheet 141. Note that the thermosetting resin 25 may be omitted, and the heat dissipation sheet 141 may be directly bonded to the semiconductor chip 26.

The semiconductor chip 26 is surrounded by the molding resin 102, and the semiconductor chip 26 is enclosed in a space surrounded by the molding resin 102. The glass holding portion 101 is provided inside the molding resin 102, and a glass substrate 28 is held by the glass holding portion 101.

The glass holding portion 101 is provided in an outer peripheral region of the semiconductor chip 26, in other words, in a region of the semiconductor chip 26 where an image pickup element is not provided. The glass substrate 28 is arranged on the glass holding portion 101. The image pickup element of the semiconductor chip 26 is in a state of being sealed by the semiconductor chip 26, the glass holding portion 101, and the glass substrate 28.

The molding resin 102 is provided outside the semiconductor chip 26, the molding resin 102 positioned on a left side in the drawing is provided on the circuit board 21, and the molding resin 102 positioned on a right side in the drawing is provided on the heat dissipation sheet 141. The semiconductor chip 26 is in a state of being sealed by the circuit board 21, the molding resin 102, and the glass substrate 28.

Note that, in the example illustrated in Fig. 21, an example in which the heat dissipation sheet 141 is formed in a region other than the lead regions 62 on the circuit board 21 has been illustrated. However, the heat dissipation sheet 141 may be formed in a part of the region other than the lead regions 62 on the circuit board 21.

In the example illustrated in Figs. 21 and 22, a case where the heat dissipation sheet 141 is formed on an outermost surface of the circuit board 21 has been described as an example. However, a layer other than the heat dissipation sheet 141 may be formed on the outermost surface of the circuit board 21, and the heat dissipation sheet 141 may be formed below the layer. For example, the present disclosure can also be applied to the semiconductor package 10c having the hollow structure illustrated in Fig. 16. Furthermore, the heat dissipation sheet 141 may be formed on the outermost surface of the circuit board 21, or the heat dissipation sheet 141 may be formed on a back surface of the semiconductor chip 26.

According to the present technology, it is possible to realize a semiconductor package that is small, lightweight, and has high heat dissipation capable of suppressing the warpage of the semiconductor chip 26 and the circuit board 21 on which the semiconductor chip 26 is mounted due to the temperature change.

### <About Connection with Housing>

The semiconductor packages 10a to 10d according to the first to fourth embodiments are configured such that a part of the heat dissipation sheet 24 (heat dissipation sheet 141) is exposed to the outside of the semiconductor package 10. The exposed portion is connected to the housing in which the semiconductor package 10 is installed, and thus, the heat of the semiconductor package 10 is transmitted to the housing.

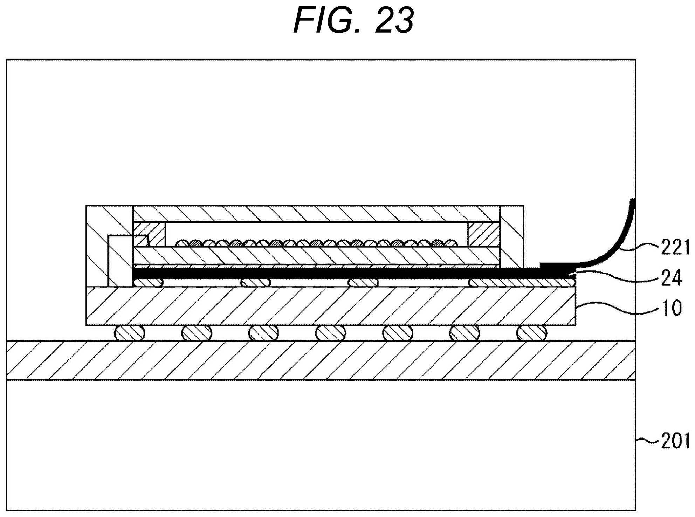

Fig. 23 is a diagram for describing a connection example of the housing and the semiconductor package 10 installed in the housing. The semiconductor package 10 is installed in a housing 201. A heat dissipation sheet 221 of the same type as the heat dissipation sheet 24 is connected to a portion where the heat dissipation sheet 24 of the semiconductor package 10 is exposed. One of the heat dissipation sheet 221 is connected to the heat dissipation sheet 24 of the semiconductor package 10, and the other is connected to a part of the housing 201.

Note that the heat dissipation sheet 24 and the heat dissipation sheet 221 may be formed by using different materials. Furthermore, the heat dissipation sheet 221 may have a plate shape, a linear shape, or the like instead of a sheet shape.

With such a configuration, the heat generated in the semiconductor package 10 is transferred to the heat dissipation sheet 221 via the heat dissipation sheet 24, is transferred to the housing 201 via the heat dissipation sheet 221, and can be dissipated from the housing 201 to an outside of the housing 201.

As described above, according to the present technology, it is possible to realize a semiconductor package that is small, lightweight, and has high heat dissipation capable of suppressing the warpage of the semiconductor chip 26 and the circuit board 21 on which the semiconductor chip 26 is mounted due to the temperature change.

### <Example of Application to Endoscopic Surgery System>

The technology according to the present disclosure (present technology) can be applied to various products. For example, the technology according to the present disclosure may be applied to an endoscopic surgery system.

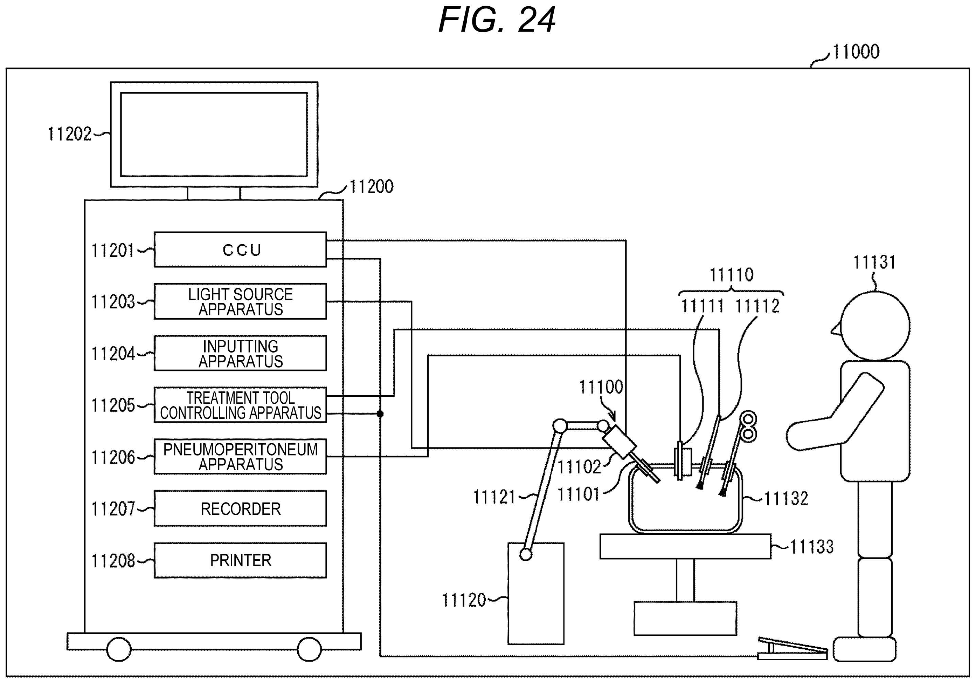

Fig. 24 is a diagram illustrating an example of a schematic configuration of an endoscopic surgery system to which the technology according to the present disclosure (present technology) can be applied.

In Fig. 24, a scene in which a surgeon (medical doctor) 11131 is using an endoscopic surgery system 11000 to perform surgery for a patient 11132 on a patient bed 11133 is illustrated. As depicted, the endoscopic surgery system 11000 includes an endoscope 11100, other surgical tools 11110 such as a pneumoperitoneum tube 11111 and an energy device 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body cavity of the patient 11132, and a camera head 11102 connected to a proximal end of the lens barrel 11101. In the example depicted, the endoscope 11100 is depicted which includes as a rigid endoscope having the lens barrel 11101 of the hard type. However, the endoscope 11100 may otherwise be included as a flexible endoscope having the lens barrel 11101 of the flexible type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body cavity of the patient 11132 through the objective lens. It is to be noted that the endoscope 11100 may be a forward-viewing endoscope or may be an oblique-viewing endoscope or a side-viewing endoscope.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy device 11112 for cautery or incision of a tissue, sealing of a blood vessel or the like. A pneumoperitoneum apparatus 11206 feeds gas into a body cavity of the patient 11132 through the pneumoperitoneum tube 11111 to inflate the body cavity in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrowband light and/or excitation light suitable for special light observation as described above.

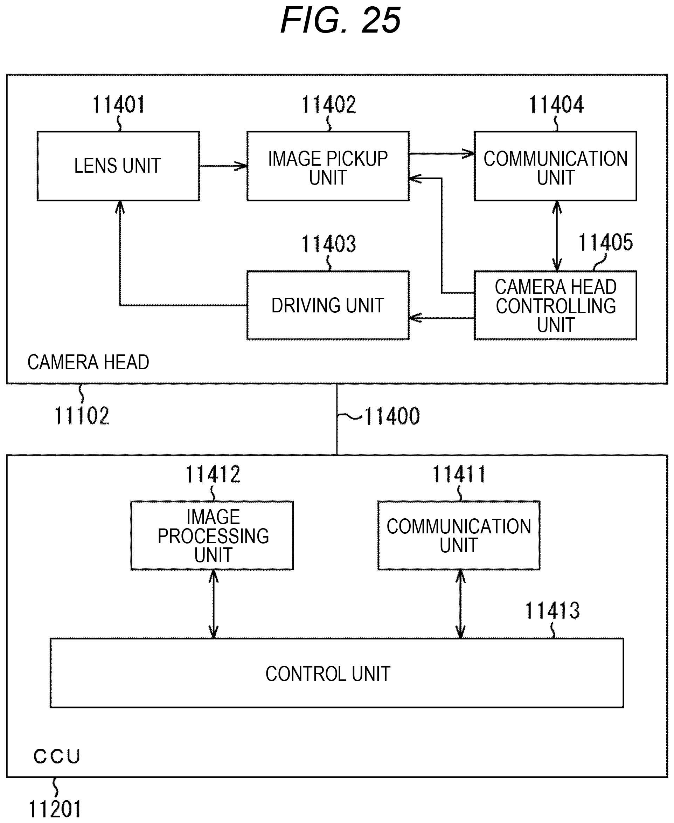

Fig. 25 is a block diagram illustrating an example of a functional configuration of the camera head 11102 and the CCU 11201 illustrated in Fig. 24.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy device 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

### <Example of Application to Mobile Body>

The technology according to the present disclosure (present technology) can be applied to various products. For example, the technology according to the present disclosure may be realized as an apparatus included in any kind of mobile body such as an automobile, an electric vehicle, a hybrid electric vehicle, a motorcycle, a bicycle, a personal mobility, an airplane, a drone, a ship, a robot, and the like.

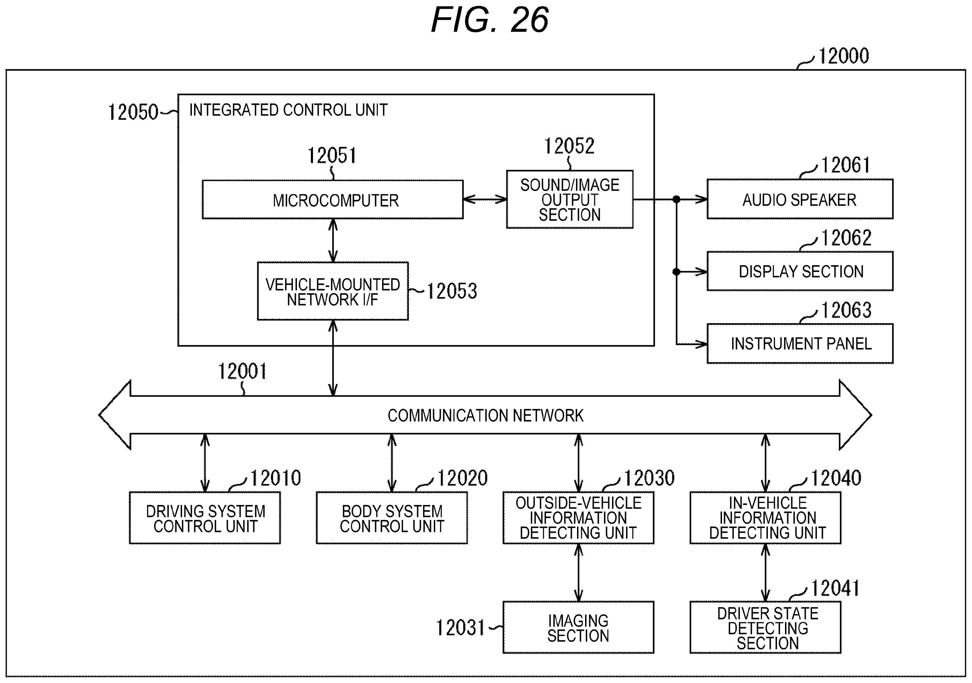

Fig. 26 is a block diagram illustrating a schematic configuration example of a vehicle control system as an example of a mobile body control system to which the technology according to the present disclosure may be applied.

The vehicle control system 12000 includes a plurality of electronic control units connected to each other via a communication network 12001. In the example illustrated in Fig. 26, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

Furthermore, the microcomputer 12051 can output a control command to the body system control unit 12030 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example in Fig. 26, an audio speaker 12061, a display section 12062, and an instrument panel 12063 are illustrated as the output devices. The display section 12062 may, for example, include at least one of an on-board display and a head-up display.

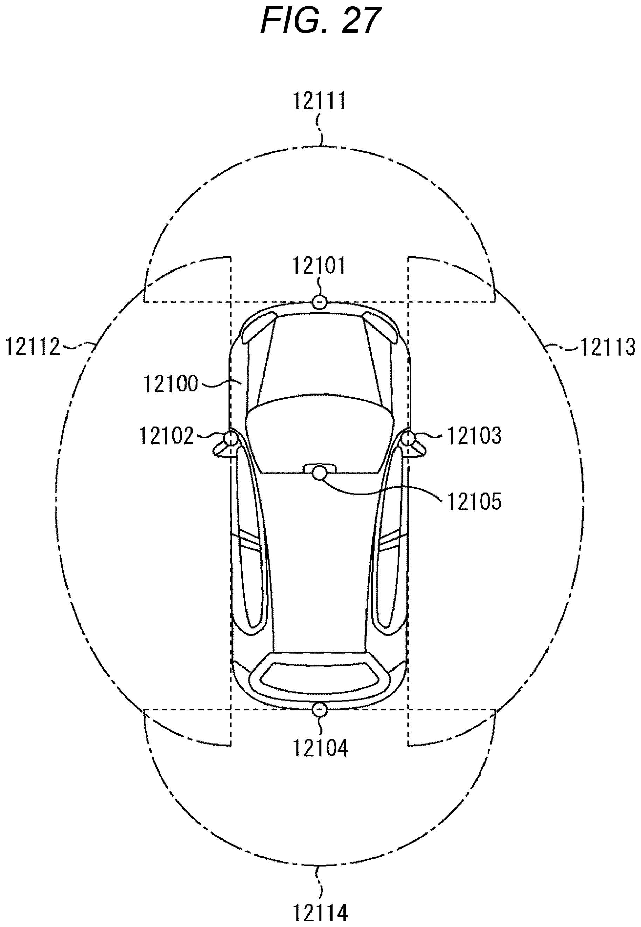

Fig. 27 is a diagram illustrating an example of an installation position of the imaging section 12031.

In Fig. 27, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Note that, Fig. 27 illustrates an example of imaging ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

In the present specification, the system represents the entire device including a plurality of devices.

Note that the effects described in this specification are merely examples and are not limited, and other effects may also be present.

Note that embodiments of the present technology are not limited to the above-described embodiments, and various changes can be made without departing from the gist of the present technology.

Note that the present technology can also have the following configurations.
(1) A semiconductor package including:
   a sheet formed by using a material having thermal conductivity;
   a semiconductor chip arranged on an upper surface side of the sheet and including a pixel array section including a photoelectric conversion element and a peripheral circuit section; and
   a circuit board arranged on a lower surface side of the sheet and processing a signal from the semiconductor chip,
   in which the sheet includes
   a gap in which a wire connecting an electrode of the semiconductor chip and an electrode of the circuit board is wired,
   a first region in which the semiconductor chip is arranged,
   a second region surrounding the first region via the gap,
   a connecting portion connecting the first region and the second region, and
   a third region connected to the second region and having at least a part arranged outside the package.
(2) The semiconductor package according to the above (1),
   in which at least a part of the connecting portion is curved or bent.
(3) The semiconductor package according to the above (1) or (2),
   in which the connecting portion includes a straight-shaped portion and a curved-shaped portion each having a predetermined width.
(4) The semiconductor package according to any one of the above (1) to (3),
   in which the connecting portion includes a straight-shaped portion and a bent portion each having a predetermined width.
(5) The semiconductor package according to any one of the above (1) to (4),
   in which the third region is provided on at least one side from one side to four sides of the second region formed in a quadrangular shape.
(6) The semiconductor package according to any one of the above (1) to (5),
   in which the connecting portion is provided at a position connecting each of four corners of the first region and each of four corners of the second region.
(7) The semiconductor package according to the above (6),
   in which the connecting portion is also provided in the gap.
(8) The semiconductor package according to any one of the above (1) to (7),
   in which the sheet is a graphite sheet.
(9) The semiconductor package according to any one of the above (1) to (7),
   in which the sheet is a sheet containing metal or ceramic.
(10) The semiconductor package according to any one of the above (1) to (9), further including:
   a first adhesive for bonding the sheet and the semiconductor chip; and
   a second adhesive for bonding the sheet and the circuit board,
   in which the first adhesive and the second adhesive are thermosetting resins having different characteristics.
(11) The semiconductor package according to the above (10),
   in which the first adhesive is a resin having a high elastic modulus, and
   the second adhesive is a resin having an elastic modulus lower than the elastic modulus of the first adhesive.
(12) The semiconductor package according to the above (10) or (11),
   in which the first adhesive is applied to an entire region on an upper surface side of the first region where the semiconductor chip is arranged, and
   the second adhesive is applied to a part of a lower surface side of the first region.
(13) The semiconductor package according to any one of the above (1) to (12),
   in which the semiconductor chip is a complementary metal-oxide-semiconductor (CMOS) image sensor or a charge-coupled device (CCD) image sensor.
(14) The semiconductor package according to any one of the above (1) to (13), further including:
   a frame; and
   a glass substrate arranged on the frame,
   in which the frame is arranged on an upper surface side of the second region, and
   the semiconductor chip is sealed by the circuit board, the frame, and the glass substrate.
(15) The semiconductor package according to any one of the above (1) to (14), further including:
   a molding resin;
   a glass holding portion; and
   a glass substrate arranged on the glass holding portion,
   in which the semiconductor chip is sealed by the circuit board, the molding resin, and the glass substrate.
(16) The semiconductor package according to the above (15),
   in which the wire is enclosed in the molding resin and the glass holding portion.
(17) The semiconductor package according to the above (15),
   in which the wire is arranged in a space between the molding resin and the semiconductor chip.
(18) An electronic device including:
   a semiconductor package that includes
   a sheet formed by using a material having high thermal conductivity,
   a semiconductor chip arranged on an upper surface side of the sheet and having a pixel array section having a photoelectric conversion element and a peripheral circuit section, and
   a circuit board arranged on a lower surface side of the sheet and processing a signal from the semiconductor chip,
   the sheet including
   a gap in which a wire connecting an electrode of the semiconductor chip and an electrode of the circuit board is wired,
   a first region in which the semiconductor chip is arranged,
   a second region surrounding the first region via the gap,
   a connecting portion connecting the first region and the second region, and
   a third region connected to the second region and having at least a part arranged outside the package.
(19) A manufacturing method including:
   bonding, by a first adhesive, a semiconductor chip to an upper surface side of a sheet including
   a gap in which a wire connecting an electrode of the semiconductor chip and an electrode of a circuit board is wired,
   a first region in which the semiconductor chip is arranged,
   a second region surrounding the first region via the gap,
   a connecting portion connecting the first region and the second region, and
   a third region connected to the second region and having at least a part arranged outside a package; and
   bonding the circuit board to a lower surface side of the sheet by a second adhesive having an elastic modulus lower than an elastic modulus of the first adhesive.

### REFERENCE SIGNS LIST

- 1: Semiconductor package
- 21: Circuit board
- 22: Thermosetting resin
- 23: Adhesive
- 24: Heat dissipation sheet
- 25: Thermosetting resin
- 26: Semiconductor chip
- 27: Frame
- 28: Glass substrate
- 29: Wire
- 51: Central portion
- 52: Peripheral portion
- 53: Connecting portion
- 54: Drawer portion
- 55: Gap
- 61: Inner lead
- 71: Curved portion
- 72: Straight portion
- 101: Glass holding portion
- 102: Molding resin
- 121: Glass holding portion
- 122: Molding resin
- 141: Heat dissipation sheet
- 201: Housing
- 221: Heat dissipation sheet

## Claims

1. A semiconductor package comprising:
a sheet formed by using a material having thermal conductivity;
a semiconductor chip arranged on an upper surface side of the sheet and including a pixel array section including a photoelectric conversion element and a peripheral circuit section; and
a circuit board arranged on a lower surface side of the sheet and processing a signal from the semiconductor chip,
wherein the sheet includes
a gap in which a wire connecting an electrode of the semiconductor chip and an electrode of the circuit board is wired,
a first region in which the semiconductor chip is arranged,
a second region surrounding the first region via the gap,
a connecting portion connecting the first region and the second region, and
a third region connected to the second region and having at least a part arranged outside the package.

2. The semiconductor package according to claim 1,
wherein at least a part of the connecting portion is curved or bent.

3. The semiconductor package according to claim 1,
wherein the connecting portion includes a straight-shaped portion and a curved-shaped portion each having a predetermined width.

4. The semiconductor package according to claim 1,
wherein the connecting portion includes a straight-shaped portion and a bent portion each having a predetermined width.

5. The semiconductor package according to claim 1,
wherein the third region is provided on at least one side from one side to four sides of the second region formed in a quadrangular shape.

6. The semiconductor package according to claim 1,
wherein the connecting portion is provided at a position connecting each of four corners of the first region and each of four corners of the second region.

7. The semiconductor package according to claim 6,
wherein the connecting portion is also provided in the gap.

8. The semiconductor package according to claim 1,
wherein the sheet is a graphite sheet.

9. The semiconductor package according to claim 1,
wherein the sheet is a sheet containing metal or ceramic.

10. The semiconductor package according to claim 1, further comprising:
a first adhesive for bonding the sheet and the semiconductor chip; and
a second adhesive for bonding the sheet and the circuit board,
wherein the first adhesive and the second adhesive are thermosetting resins having different characteristics.

11. The semiconductor package according to claim 10,
wherein the first adhesive is a resin having a high elastic modulus, and
the second adhesive is a resin having an elastic modulus lower than the elastic modulus of the first adhesive.

12. The semiconductor package according to claim 10,
wherein the first adhesive is applied to an entire region on an upper surface side of the first region where the semiconductor chip is arranged, and
the second adhesive is applied to a part of a lower surface side of the first region.

13. The semiconductor package according to claim 1,
wherein the semiconductor chip is a complementary metal-oxide-semiconductor (CMOS) image sensor or a charge-coupled device (CCD) image sensor.

14. The semiconductor package according to claim 1, further comprising:
a frame; and
a glass substrate arranged on the frame,
wherein the frame is arranged on an upper surface side of the second region, and
the semiconductor chip is sealed by the circuit board, the frame, and the glass substrate.

15. The semiconductor package according to claim 1, further comprising:
a molding resin;
a glass holding portion; and
a glass substrate arranged on the glass holding portion,
wherein the semiconductor chip is sealed by the circuit board, the molding resin, and the glass substrate.

16. The semiconductor package according to claim 15,
wherein the wire is enclosed in the molding resin and the glass holding portion.

17. The semiconductor package according to claim 15,
wherein the wire is arranged in a space between the molding resin and the semiconductor chip.

18. An electronic device comprising:
a semiconductor package that includes
a sheet formed by using a material having high thermal conductivity,
a semiconductor chip arranged on an upper surface side of the sheet and having a pixel array section having a photoelectric conversion element and a peripheral circuit section, and
a circuit board arranged on a lower surface side of the sheet and processing a signal from the semiconductor chip,
the sheet including
a gap in which a wire connecting an electrode of the semiconductor chip and an electrode of the circuit board is wired,
a first region in which the semiconductor chip is arranged,
a second region surrounding the first region via the gap,
a connecting portion connecting the first region and the second region, and
a third region connected to the second region and having at least a part arranged outside the package.

19. A manufacturing method comprising:
bonding, by a first adhesive, a semiconductor chip to an upper surface side of a sheet including
a gap in which a wire connecting an electrode of the semiconductor chip and an electrode of a circuit board is wired,
a first region in which the semiconductor chip is arranged,
a second region surrounding the first region via the gap,
a connecting portion connecting the first region and the second region, and
a third region connected to the second region and having at least a part arranged outside a package; and
bonding the circuit board to a lower surface side of the sheet by a second adhesive having an elastic modulus lower than an elastic modulus of the first adhesive.
